(19) Europäisches Patentamt
European Patent Office
Office européen des brevets

(11) EP 4 800 743 A1

# (12) EUROPEAN PATENT APPLICATION

published in accordance with Art. 153(4) EPC

(43) Date of publication:
**02.09.2026 Bulletin 2026/36**

(21) Application number: **24897598.9**

(22) Date of filing: **27.11.2024**

(51) International Patent Classification (IPC):
***H01L 21/60*** *(2006.01)* ***C22C 21/02*** *(2006.01)*
***C22F 1/00*** *(2006.01)* ***C22F 1/043*** *(2006.01)*

(52) Cooperative Patent Classification (CPC):
**C22C 21/00; C22C 21/02; C22F 1/00; C22F 1/04; C22F 1/043; H10W 72/071**

(86) International application number:
**PCT/JP2024/042019**

(87) International publication number:
**WO 2025/115914 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**27.11.2023 PCT/JP2023/042366**
**27.11.2023 PCT/JP2023/042369**
**27.11.2023 PCT/JP2023/042371**
**27.11.2023 PCT/JP2023/042373**
**27.11.2023 PCT/JP2023/042374**
**04.06.2024 PCT/JP2024/020313**
**04.06.2024 PCT/JP2024/020314**

(71) Applicants:
- **NIPPON STEEL CHEMICAL & MATERIAL CO., LTD.**
**Tokyo 103-0027 (JP)**
- **Nippon Micrometal Corporation**
**Iruma-shi**
**Saitama 358-0032 (JP)**

(72) Inventors:
- **UNO, Tomohiro**
**Tokyo 100-8071 (JP)**
- **SUTO, Yuya**
**Tokyo 100-8071 (JP)**
- **ODA, Daizo**
**Iruma-shi, Saitama 358-0032 (JP)**
- **ETO, Motoki**
**Iruma-shi, Saitama 358-0032 (JP)**
- **KOZAWA, Norihiro**
**Iruma-shi, Saitama 358-0032 (JP)**

(74) Representative: **Grünecker Patent- und Rechtsanwälte**
**PartG mbB**
**Leopoldstraße 4**
**80802 München (DE)**

## (54) ALUMINUM BONDING WIRE OR ALUMINUM BONDING RIBBON

(57) To provide an Al bonding wire or an Al bonding ribbon that exhibits excellent rapid temperature cycle reliability even in a rapid temperature cycle test having a large number of cycles, which is required for next-generation SiC power semiconductors. The Al bonding wire or the Al bonding ribbon contains 3.0% by mass or more and 20.0% by mass or less of Si, wherein, when a crystal orientation of an Al phase in an L cross-section (cross section in a center axis direction including a center axis) of the Al bonding wire or the Al bonding ribbon is measured, an orientation ratio of a <100> crystal orientation angled at 15° or less to a direction parallel to the center axis (RD direction) is equal to or larger than 15% and equal to or smaller than 50%, and when Ns denotes the number of Si phases having an equivalent circle diameter equal to or larger than 0.5 μm and equal to or smaller than 0.8 μm in the L cross-section and Nc denotes the number of Si phases having an equivalent circle diameter equal to or larger than 0.5 μm in the L cross-section, a ratio of Ns to Nc [Ns/Nc × 100 (%)] is equal to or larger than 30% and equal to or smaller than 95%.

EP 4 800 743 A1

## Description

### TECHNICAL FIELD

The present invention relates to an Al bonding wire or an Al bonding ribbon. The present invention further relates to a semiconductor device obtained by using the Al bonding wire or the Al bonding ribbon.

### BACKGROUND ART

In a semiconductor device, electrodes formed on a semiconductor chip are connected with a lead frame or electrodes on a substrate via a bonding wire (wire material) or a bonding ribbon (bar material). In a power semiconductor device, used is a bonding wire or a bonding ribbon made mainly of aluminum (Al) as a material. A wire diameter of the Al bonding wire mainly falls within a range from 100 μm to 600 μm. A width of the Al bonding ribbon mainly falls within a range from 100 μm to 3000 μm, and a thickness thereof falls within a range from 50 μm to 600 μm. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al bonding wire or the Al bonding ribbon are often used as large power equipment such as air conditioners and photovoltaic power generation systems, or as vehicle-mounted semiconductor devices.

A bonding method for the Al bonding wire or the Al bonding ribbon includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al bonding wire or the Al bonding ribbon via a jig (tool) made of metal, breaking surface oxide films of the Al bonding wire or the Al bonding ribbon and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire or the Al bonding ribbon, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al bonding wire or the Al bonding ribbon and the semiconductor chip, is repeatedly applied to the 1st bonding part. In a case of using a connection material made only of high-purity Al, the Al bonding wire or the Al bonding ribbon is broken in a relatively short time due to thermal stress, so that it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 μm. This Patent Literature discloses that it is possible to suppress lowering of bonding strength of the 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

## RELATED ART REFERENCE

### Patent Literature

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

## SUMMARY OF INVENTION

## PROBLEM TO BE SOLVED BY THE INVENTION

As described above, the next-generation power semiconductor device is required to withstand a longer-time use as compared with a general-purpose power semiconductor device. The temperature of the 1st bonding part repeatedly rises and falls at the time when the power semiconductor device operates. As a result, because the Al bonding wire or the Al bonding ribbon has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al bonding wire or the Al bonding ribbon. A temperature cycle test is one of the tests for evaluating, in an accelerated manner, a lifetime of wire (or ribbon) bond accompanying a temperature rise and a temperature fall of the 1st bonding part (temperature cycle reliability). The Al bonding wire or the Al bonding ribbon used for the next-generation power semiconductor is required to exhibit excellent temperature cycle reliability in the temperature cycle test.

However, the present inventors have confirmed that, in a case of using the Al bonding wire that is highly strengthened by adding Si and the like thereto as disclosed in Patent Literatures 1 to 3, there is a problem in that a crack develops at a relatively high speed in an Al alloy electrode having lower strength than that of the Al bonding wire in a temperature cycle test assuming a use in the next-generation power semiconductor device, and favorable temperature cycle reliability is difficult to be stably obtained.

On the other hand, a conventional temperature cycle test (hereinafter, also referred to as "Temperature Cycle Test (TCT)") can be easily performed by using a commercially available testing apparatus. However, a changing speed of a temperature in the TCT is relatively slow, so that there is concern about a deviation from a fast temperature changing speed at the time when the power semiconductor device operates. Thus, recently, a rapid temperature cycle test (hereinafter, also referred to as a "rapid TCT"), in which the temperature changing speed is increased, has been examined to be brought closer to a condition of real use. The changing speed of the temperature is, for example, about 10°C/minute in the conventional TCT, while the temperature changes at high speed such as about 200°C/minute in the rapid TCT, for example. Regarding evaluation of reliability of a bonding part of the Al bonding wire or the Al bonding ribbon, the present inventors have confirmed that, even with the Al bonding wire or the Al bonding ribbon the reliability of which is not lowered when it is evaluated by the conventional TCT, bonding strength may be lowered and a lifetime of wire (or ribbon) bond may be shortened when it is evaluated by the rapid TCT. Thus, there is a demand for an Al bonding wire or an Al bonding ribbon that exhibits favorable reliability of the bonding part and excellent temperature cycle reliability even in the rapid TCT that is a more rigorous test close to the condition of real use. Hereinafter, temperature cycle reliability in the rapid TCT may also be referred to as "rapid temperature cycle reliability".

In next-generation power semiconductor elements that replace silicon (Si), which has been mainstream, use of silicon carbide (SiC) having high heat resistance is predicted to advance. In a connection for a SiC power semiconductor, a rapid temperature cycle test that is more severe than a current rapid temperature cycle test is required. For example, the number of cycles of the rapid temperature cycle test for a Si semiconductor is about 10,000 cycles, whereas for a SiC semiconductor, the number of cycles is required to be extended to about 20,000 cycles. An upper limit temperature for a Si semiconductor is required to be about 150°C, which is a severe condition, whereas for a SiC semiconductor, excellent rapid temperature cycle reliability is required to be exhibited under a more severe condition, such as a temperature exceeding 175°C. Herein, the present inventors have found that, even in a case of the Al bonding wire or the Al bonding ribbon that exhibits excellent rapid temperature cycle reliability at about 10,000 cycles, when the number of cycles of the rapid temperature cycle test is set to 20,000 cycles for a SiC semiconductor, a problem may arise in that the strength of a bonding part of the Al bonding wire or the Al bonding ribbon deteriorates, and the rapid temperature cycle reliability may be inferior. This is considered to be because, as the number of temperature cycles increases, a form, a location, and an extension behavior of a crack generated at the bonding part of the Al bonding wire or the Al bonding ribbon change. Therefore, when the number of cycles increases from 10,000 cycles to 20,000 cycles, a ratio of cracks generated inside the Al bonding wire or the Al bonding ribbon rapidly increases, and this is considered to be a factor that accelerates a decrease

in reliability.

The present invention has been made in view of the above problem, and aims at providing an Al bonding wire or an Al bonding ribbon that exhibits excellent rapid temperature cycle reliability even in a rapid temperature cycle test having a large number of cycles, which is required for next-generation SiC power semiconductors.

## MEANS FOR SOLVING PROBLEM

As a result of earnest investigation as to the problem described above, the present inventors have found that the problem described above can be solved by an Al bonding wire or an Al bonding ribbon containing 3.0% by mass or more and 20.0% by mass or less of Si, wherein an orientation ratio of a <100> crystal orientation of an Al phase in an RD direction in an L cross-section (cross section in a center axis direction including a center axis) of the Al bonding wire or the Al bonding ribbon, and a ratio of the number of Si phases having an equivalent circle diameter equal to or larger than 0.5 μm and equal to or smaller than 0.8 μm in the L cross-section fall within a specific range, and have further investigated the problem based on such knowledge to complete the present invention.

That is, the present invention includes the following content.

<1> An Al bonding wire or an Al bonding ribbon containing 3.0% by mass or more and 20.0% by mass or less of Si, wherein

when a crystal orientation of an Al phase in an L cross-section (cross section in a center axis direction including a center axis) of the Al bonding wire or the Al bonding ribbon is measured, an orientation ratio of a <100> crystal orientation angled at 15° or less to a direction parallel to the center axis (RD direction) is equal to or larger than 15% and equal to or smaller than 50%, and

when Ns denotes the number of Si phases having an equivalent circle diameter equal to or larger than 0.5 μm and equal to or smaller than 0.8 μm in the L cross-section and Nc denotes the number of Si phases having an equivalent circle diameter equal to or larger than 0.5 μm in the L cross-section, a ratio of Ns to Nc [Ns/Nc × 100 (%)] is equal to or larger than 30% and equal to or smaller than 95%.

<2> The Al bonding wire or the Al bonding ribbon according to <1>, wherein the ratio of Ns to Nc [Ns/Nc × 100 (%)] is equal to or larger than 40%.

<3> The Al bonding wire or the Al bonding ribbon according to <1> or <2>, wherein, when a crystal orientation of the Si phase in the L cross-section is measured, a total of orientation ratios of a <100> crystal orientation and a <111> crystal orientation angled at 15° or less to a direction perpendicular to the center axis (ND direction) is equal to or larger than 20% and equal to or smaller than 60%.

<4> The Al bonding wire or the Al bonding ribbon according to any one of <1> to <3>, wherein an average value of a ratio between a short side length e and a long side length f (e/f) of the Si phase in the L cross-section is equal to or larger than 0.20 and equal to or smaller than 0.70.

<5> The Al bonding wire or the Al bonding ribbon according to any one of <1> to <4>, further containing 10 mass ppm or more and 800 mass ppm or less of one or more of Sr, Na, Fe, and P in total.

<6> The Al bonding wire or the Al bonding ribbon according to any one of <1> to <5>, further containing 100 mass ppm or more and 2000 mass ppm or less of one or more of Ti, Ni, Mg, and Cu in total.

<7> The Al bonding wire or the Al bonding ribbon according to any one of <1> to <6>, wherein a total concentration of elements other than Al, Si, Sr, Na, Fe, P, Ti, Ni, Mg, and Cu in the Al bonding wire or the Al bonding ribbon is equal to or smaller than 0.5% by mass.

<8> The Al bonding wire or the Al bonding ribbon according to any one of <1> to <7>, wherein the orientation ratio of the crystal orientation, the equivalent circle diameter of the Si phase, and the number of Si phases are values measured by using a SEM-EDS-EBSD apparatus.

<9> The Al bonding wire or the Al bonding ribbon according to any one of <4> to <8>, wherein the average value of the ratio between the short side length e and the long side length f (e/f) of the Si phase is a value measured by using a SEM-EDS-EBSD apparatus.

<10> The Al bonding wire or the Al bonding ribbon according to any one of <1> to <9>, used for a semiconductor device.

<11> A semiconductor device comprising the Al bonding wire or the Al bonding ribbon according to any one of <1> to <10>.

## EFFECT OF THE INVENTION

According to the present invention, it is possible to provide an Al bonding wire or an Al bonding ribbon that exhibits

excellent rapid temperature cycle reliability even in a rapid temperature cycle test having a large number of cycles, which is required for next-generation SiC power semiconductors, and a semiconductor device obtained by using the Al bonding wire or the Al bonding ribbon.

## BRIEF DESCRIPTION OF DRAWINGS

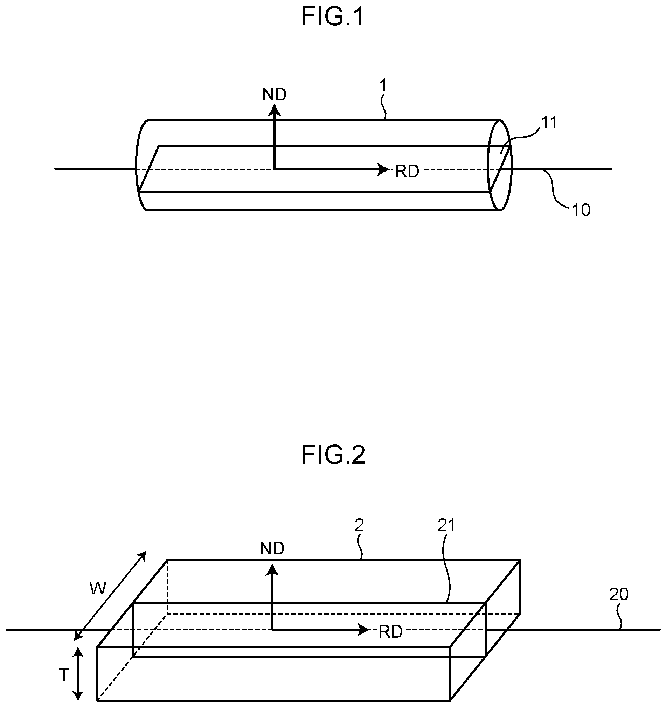

FIG. 1 is a schematic diagram for explaining, regarding an Al bonding wire, a measurement target surface (inspection surface) when measuring crystal orientations of an Al phase and a Si phase, a small-diameter ratio of the Si phase, and a shape of the Si phase. FIG. 1 is also a schematic diagram for explaining, regarding an Al bonding wire, an RD direction and an ND direction. The measurement target surface is a cross section in a center axis direction including a center axis (L cross-section) of the Al bonding wire.
FIG. 2 is a schematic diagram for explaining, regarding an Al bonding ribbon, a measurement target surface (inspection surface) when measuring crystal orientations of the Al phase and the Si phase, a small-diameter ratio of the Si phase, and a shape of the Si phase. FIG. 2 is also a schematic diagram for explaining, regarding an Al bonding ribbon, an RD direction and an ND direction. The measurement target surface is a cross section in a center axis direction including a center axis (L cross-section) of the Al bonding ribbon.

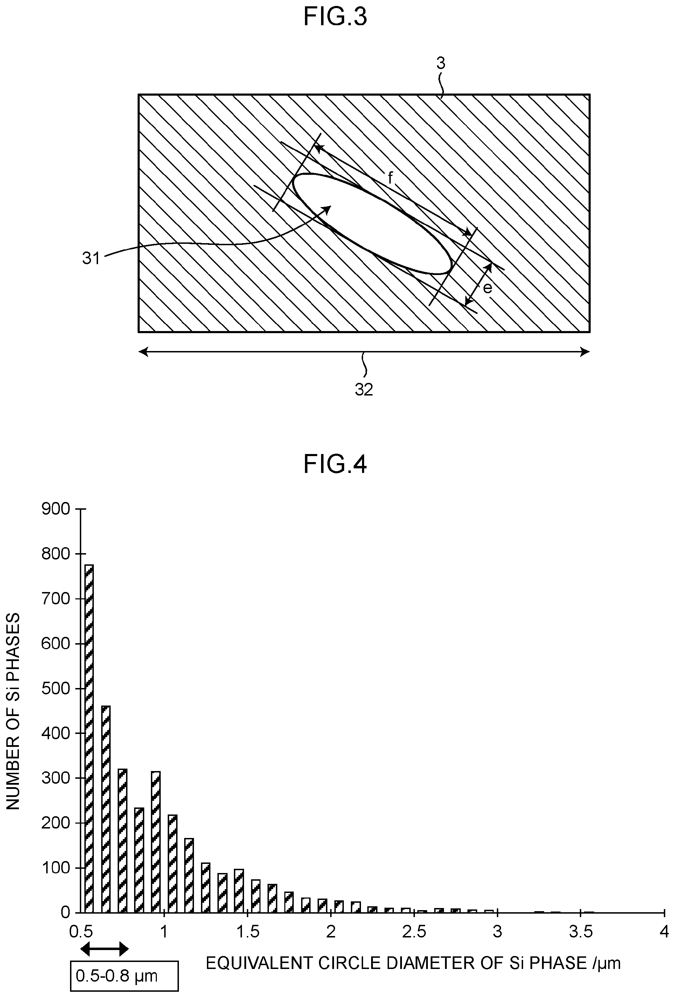

FIG. 3 is a schematic diagram for explaining a short side length (e) and a long side length (f) of the Si phase in the L cross-section.
FIG. 4 is an example of a graph representing number distribution of an equivalent circle diameter of the Si phase in the L cross-section.

## EMBODIMENT FOR CARRYING OUT THE INVENTION

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

[Al bonding wire or Al bonding ribbon]

An Al bonding wire or an Al bonding ribbon according to the present invention is an Al bonding wire or an Al bonding ribbon containing 3.0% by mass or more and 20.0% by mass or less of Si, wherein

when a crystal orientation of an Al phase in an L cross-section (cross section in a center axis direction including a center axis) of the Al bonding wire or the Al bonding ribbon is measured, an orientation ratio of a <100> crystal orientation angled at 15° or less to a direction parallel to the center axis (RD direction, Rolling direction) (hereinafter, also referred to as an "orientation ratio of the <100> crystal orientation of the Al phase in the RD direction") is equal to or larger than 15% and equal to or smaller than 50%, and,
when Ns denotes the number of Si phases having an equivalent circle diameter equal to or larger than 0.5 μm and equal to or smaller than 0.8 μm in the L cross-section and Nc denotes the number of Si phases having an equivalent circle diameter equal to or larger than 0.5 μm in the L cross-section, a ratio of Ns to Nc [Ns/Nc × 100 (%)] is equal to or larger than 30% and equal to or smaller than 95%.

As described above, in a case of using a connection material composed only of high-purity Al in a temperature cycle test, there is a problem in that a crack develops at a relatively high speed inside the connection material, and temperature cycle reliability is lowered. It has been confirmed that, in an Al alloy to which Si is added at a high concentration, thermal expansion of a wire can be reduced, and temperature cycle reliability can be improved. In a rapid temperature cycle test (rapid TCT) in which a temperature changing speed is increased to be close to a condition of real use, it has been confirmed that, even with an Al bonding wire or an Al bonding ribbon the reliability of which is not lowered when being evaluated by a conventional TCT, bonding strength may be lowered and a lifetime of wire (or ribbon) bond may be shortened. Furthermore, regarding the Al bonding wire or the Al bonding ribbon that is highly strengthened by adding Si and the like thereto, an internal crack may be generated at the time of manufacture thereof. In addition, when the number of temperature cycles of the rapid TCT considerably increases, the bonding strength is more likely to be lowered, and further improvement in rapid temperature cycle reliability is necessary to satisfy rapid temperature cycle reliability required for a next-generation power semiconductor device having high heat resistance, such as SiC.

Herein, the present inventors have clarified that, due to an increase in the number of cycles in the rapid temperature cycle test, a failure occurrence mode and a failure occurrence factor change at a bonding part of a wire or a ribbon. Although it varies depending on detailed conditions of a temperature history, crack development inside a wire or a ribbon is dominant up to about 10,000 temperature cycles, whereas when the number of temperature cycles exceeds 15,000 cycles, crack development at a bonding interface and crack development inside an electrode occur in a combined manner, thereby lowering reliability. Although it may be difficult to distinguish between a crack at the bonding interface and a crack inside the electrode in observation of a bonding cross section, it has been found that it is effective to separate the two types of cracks when a high number of cycles is performed and to organize a relation between them and a wire structure or a ribbon structure.

It has been confirmed that since stress tends to concentrate at the bonding interface in the rapid TCT, a generation rate of cracks at the bonding interface increases as compared with a normal TCT. In addition to suppressing cracks inside the wire or the ribbon generated from a low number of cycles, when the test proceeds to 20,000 cycles, it becomes important to suppress a crack at the bonding interface and a crack inside the electrode at the same time. The above-described number of cycles is an example of a numerical value serving as a guideline under a certain condition of the rapid TCT, and a required number of cycles varies depending on a test condition (a temperature, a time, and a temperature increase/decrease rate) of the rapid TCT and/or a semiconductor element to be used.

As a result of earnest investigation as to the problem described above, the present inventors have clarified that, in an Al bonding wire or an Al bonding ribbon containing 3.0% by mass or more and 20.0% by mass or less of Si, by adjusting the orientation ratio of the <100> crystal orientation of the Al phase in a direction parallel to the center axis (RD direction) in the L cross-section and number distribution of the Si phase in a region where an equivalent circle diameter in the L cross-section is relatively small (a ratio of the number of Si phases having an equivalent circle diameter within a specific range to a total number of Si phases) at the same time, reliability in the rapid TCT with a considerably large number of temperature cycles is improved, thereby contributing to a longer lifetime. By mutually controlling a structure from different viewpoints of the crystal orientation of the Al phase and the number distribution of the Si phase, it is possible to improve rapid temperature cycle reliability even in a severe rapid TCT.

The Al bonding wire or the Al bonding ribbon according to the present invention contains 3.0% by mass or more and 20.0% by mass or less of Si, and includes the Al phase in which Si is dissolved in Al as a solid solution and a Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 25 μm, which is coarse. On the other hand, the Si precipitate is formed from a solid state, and has a small size of about 0.1 μm to several micrometers.

In the present invention, a "wire" and a "ribbon" are classified not by a shape but by a manufacturing method thereof. That is, the term "wire" refers to "a connection material manufactured by wire-drawing processing using a die", and the term "ribbon" refers to "a connection material manufactured by a rolling process". A "wire" usually has a circular cross-sectional shape, and a "ribbon" usually has a rectangular or substantially rectangular cross-sectional shape.

In the present invention, the term "ND direction" refers to a direction that satisfies both "a direction perpendicular to the center axis" and "a direction perpendicular to a rolling surface". In a case of a wire, since force is applied from all directions in wire-drawing processing using a die, there is arbitrariness in how the ND direction is defined, and there is also arbitrariness in how the L cross-section (a cross section in the center axis direction including the center axis) is defined; however, it is common to define the L cross-section and the ND direction to be perpendicular to each other, and such a definition is also adopted in the present invention. In a case of a ribbon, the "ND direction" is uniquely determined by definition of "a direction perpendicular to the rolling surface". On the other hand, in a case of a ribbon, the L cross-section can be defined in two ways: "a cross section perpendicular to a width W direction" and "a cross section perpendicular to a thickness T direction". For ease of cross-sectional polishing and EBSD analysis, the L cross-section is defined as the "cross section perpendicular to the width W direction" (FIG. 2).

That is, regarding the Al bonding wire, the center axis, the cross section in the center axis direction including the center axis (L cross-section), the RD direction, and the ND direction are as illustrated in FIG. 1. FIG. 1 illustrates a case of the Al bonding wire having a circular cross-sectional shape. In a case of the Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and perpendicular to the width W direction (FIG. 2). Specifically, regarding the Al bonding ribbon, the center axis, the cross section in the center axis direction including the center axis (L cross-section), the RD direction, and the ND direction are as illustrated in FIG. 2. When cross-sectional processing is performed to expose the L cross-section of the Al bonding wire, it may be deviated from the center axis of the Al bonding wire. At this point, if the length of the L cross-section in the direction perpendicular to the center axis is 90% or more of a wire diameter of the Al bonding wire, the cross section can be regarded as a cross section including the center axis.

A reason why the Al bonding wire or the Al bonding ribbon according to the present invention can exhibit excellent reliability even in a rapid temperature cycle test with a considerably large number of cycles is estimated as follows.

First, regarding rapid temperature cycle reliability, the Si phase has a smaller coefficient of linear thermal expansion than that of Al, contributes to reduction of a difference in coefficient of linear thermal expansion between the Al bonding wire or the Al bonding ribbon and the semiconductor chip, and is therefore considered to be capable of reducing generated thermal stress. It is also considered that a particulate Si phase may suppress growth of a crack into an inner part of the Al bonding wire or the Al bonding ribbon. Up to about 10,000 cycles of the rapid TCT, it is effective, for improving reliability, to utilize an effect of the Si phase to lower a coefficient of linear thermal expansion and to adjust a crystal orientation of the Al bonding wire or the Al bonding ribbon that enhances the effect. On the other hand, when the number of temperature cycles increases to exceed 15,000 cycles, a part and behavior influenced by thermal distortion vary, the thermal distortion being accumulated at the bonding interface of the Al bonding wire or the Al bonding ribbon and inside the electrode serving as a bonding counterpart. Therefore, in a bonding part that can withstand 20,000 cycles, it is considered that effects of the crystal orientation of the Al phase and/or a particle diameter distribution of the Si phase, which respectively influence a crack at the bonding interface of the Al bonding wire or the Al bonding ribbon and a crack inside the electrode described above, become stronger. Specifically, when the crystal orientation of the Al phase in the L cross-section is measured, by setting the orientation ratio of the <100> crystal orientation angled at 15° or less to a direction parallel to the center axis (RD direction) to be equal to or larger than 15% and equal to or smaller than 50%, an increase in stress in the Al bonding wire or the Al bonding ribbon in the rapid TCT is relieved, and as a result, an effect of suppressing development of a crack inside the electrode can be enhanced. In addition, when Ns denotes the number of Si phases having an equivalent circle diameter equal to or larger than 0.5 μm and equal to or smaller than 0.8 μm in the L cross-section and Nc denotes the number of Si phases having an equivalent circle diameter equal to or larger than 0.5 μm in the L cross-section, by setting a ratio of Ns to Nc [Ns/Nc × 100 (%)] to be equal to or larger than 30% and equal to or smaller than 95%, an effect of suppressing development of a crack at a bonding interface of the wire or the ribbon can be enhanced.

The present invention is characterized in that an effect is enhanced by mutual involvement of the crystal orientation of the Al phase in the RD direction and the number distribution of the equivalent circle diameter of the Si phase, and respective effects thereof will be individually described. When the orientation ratio of the <100> crystal orientation of the Al phase in the RD direction falls within a range equal to or larger than 15% and equal to or smaller than 50%, an increase in stress in the wire or the ribbon during temperature rise and fall is relieved, and the influence thereof extends to an adjacent electrode, thereby making it possible to utilize an effect of suppressing development of a crack inside the electrode. By satisfying the number distribution of Si phases having a small equivalent circle diameter at the same time, it is possible to uniformize distribution of thermal distortion in the vicinity of the bonding interface, thereby enhancing a role of suppressing development of a crack at the bonding interface. That is, by combining an effect of mainly reducing crack growth inside the electrode by control of the <100> crystal orientation of the Al phase in the RD direction and an effect of reducing crack growth at the bonding interface by control of the number distribution of the Si phase having a small equivalent circle diameter at the same time, it is possible to extend a time to occurrence of failure in the bonding part under a severe test condition in which the number of temperature cycles in the rapid TCT is about 20,000 cycles. Control of the <100> orientation of the Al phase in the RD direction alone has an effect of suppressing a crack into the wire or the ribbon, and control of the number distribution of the Si phase having a small equivalent circle diameter alone has an effect of suppressing development of a crack inside the electrode; however, by controlling both of these at the same time, a synergistic effect can be enhanced.

Around the Si phase having a large equivalent circle diameter, stress and/or distortion may be generated, and/or the Si phase itself may serve as a starting point of a crack. This is related to the fact that the temperature changes more drastically in the rapid TCT than in a normal TCT, so that influences of such stress concentration and/or distortion are enhanced. On the other hand, it is considered that, by reducing a grain size of the Si phase, stress concentration and distortion in the vicinity of the bonding interface can be relatively uniformly reduced. Therefore, control of the number distribution of the Si phases having a small equivalent circle diameter relative to a total number of the Si phases is effective for a longer lifetime in the rapid temperature cycle test. Under a condition for suppressing crack development inside the wire or the ribbon when the number of cycles is small, an average value of the equivalent circle diameter of the Si phase exhibits a certain effect; however, in a long-cycle test such as including 20,000 cycles, variation in test results can be suppressed by controlling the number distribution of the Si phases having a small equivalent circle diameter relative to a total number of the Si phases, and rapid temperature cycle reliability can be stably improved.

As described above, it is estimated that the Al bonding wire or the Al bonding ribbon of the present invention can provide excellent rapid temperature cycle reliability as previously mentioned, as a result of appropriate control, within a wide range of the number of cycles, of factors contributing to improvement in temperature cycle reliability in the rapid temperature cycle test.

-Si concentration-

A Si concentration in a range equal to or larger than 3.0% by mass and equal to or smaller than 20.0% by mass is useful in reducing thermal distortion of the bonding part and improving rapid temperature cycle reliability. Specifically,

when the Si concentration is equal to or larger than 3.0% by mass, an improvement effect in rapid temperature cycle reliability can be increased. In addition, regarding an upper limit of the Si concentration, along with progress and optimization of equipment and conditions used for manufacturing and bonding of a wire or the like, higher values have become allowable while suppressing defects such as wire breakage during processing, deterioration of surface properties, reduction in initial bonding strength due to hardening, and damage to the semiconductor chip; however, when the Si concentration is equal to or smaller than 20.0% by mass, these defects can be favorably suppressed while achieving intended rapid temperature cycle reliability. From a viewpoint of obtaining favorable rapid temperature cycle reliability, the concentration of Si in the Al bonding wire or the Al bonding ribbon according to the present invention is equal to or larger than 3.0% by mass, preferably equal to or larger than 3.5% by mass, more preferably equal to or larger than 4.0% by mass, even more preferably equal to or larger than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. In addition, from a viewpoint of achieving intended rapid temperature cycle reliability while favorably suppressing defects such as reduction in initial bonding strength due to hardening and damage to the semiconductor chip, the concentration of Si in the Al bonding wire or the Al bonding ribbon according to the present invention is equal to or smaller than 20.0% by mass, and preferably equal to or smaller than 19.0% by mass, equal to or smaller than 18.0% by mass, equal to or smaller than 17.0% by mass, equal to or smaller than 16.0% by mass, equal to or smaller than 15.0% by mass, equal to or smaller than 14.5% by mass, equal to or smaller than 14.0% by mass, equal to or smaller than 13.5% by mass, equal to or smaller than 13.0% by mass, or equal to or smaller than 12.5% by mass. Furthermore, when hardness of the Al bonding wire or the Al bonding ribbon is high, the semiconductor chip tends to be easily damaged at the time of 1st bonding depending on bonding conditions of ultrasonic vibrations and loads. From a viewpoint of obtaining favorable bonding strength under a wider range of bonding conditions, the Si concentration in the Al bonding wire or the Al bonding ribbon according to the present invention is more preferably equal to or smaller than 12.0% by mass, still more preferably equal to or smaller than 11.5% by mass or equal to or smaller than 11.0% by mass, and particularly preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al bonding wire or the Al bonding ribbon according to the present invention, for example, an Inductively Coupled Plasma (ICP) emission spectrophotometer or an ICP mass spectrometer can be used. In a case in which elements derived from contaminants in the air, such as oxygen and/or carbon, are adsorbed on a surface of the Al bonding wire or the Al bonding ribbon, it is effective to clean it with acid and/or alkali depending on adsorbed substances before performing analysis.

-Crystal orientation of Al phase in L cross- section-

From a viewpoint of obtaining excellent rapid temperature cycle reliability even in the rapid TCT with a large number of cycles, when a crystal orientation of the Al phase in the L cross-section of the Al bonding wire or the Al bonding ribbon is measured, an orientation ratio of the <100> crystal orientation angled at 15° or less to a direction parallel to the center axis (RD direction) is equal to or larger than 15%, preferably equal to or larger than 20%, more preferably equal to or larger than 22%, equal to or larger than 24%, equal to or larger than 26%, or equal to or larger than 28%, still more preferably equal to or larger than 30%, and even more preferably equal to or larger than 35%. From a viewpoint of obtaining excellent rapid temperature cycle reliability in the rapid TCT with a larger number of cycles, an upper limit of the orientation ratio of the <100> crystal orientation of the Al phase in the RD direction is equal to or smaller than 50%, preferably equal to or smaller than 48% or equal to or smaller than 45%, more preferably equal to or smaller than 42%, and still more preferably equal to or smaller than 40%.

Herein, by setting the orientation ratio of the <100> crystal orientation of the Al phase in the RD direction to be equal to or larger than 15%, a length of a crack inside the electrode rapidly decreases in the rapid temperature cycle test. In addition, by setting the orientation ratio of the <100> crystal orientation of the Al phase in the RD direction to be equal to or smaller than 50%, it is possible to obtain favorable metallic bonding with the electrode at the time of bonding. Due to the above two factors, in a case in which the orientation ratio of the <100> crystal orientation of the Al phase in the RD direction is set to be equal to or larger than 15% and equal to or smaller than 50%, a decrease in bonding strength after 20,000 cycles in the rapid temperature cycle test is significantly suppressed.

-Method for measuring crystal orientation of Al phase-

The orientation ratio of the crystal orientation of the Al phase in the L cross-section of the Al bonding wire or the Al bonding ribbon can be measured by using a SEM-EDS-EBSD apparatus. Specifically, a method of combining information of Al concentration and Si concentration obtained by Scanning Electron Microscope-Energy Dispersive X-ray Spectroscopy (SEM-EDS) and information of a crystal orientation obtained by Electron BackScatter Diffraction (EBSD) can be used. More specifically, in a measurement region designating the L cross-section of the Al bonding wire or the Al bonding

ribbon to be an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions KK) attached to a Field Emission-Scanning Electron Microscope (FE-SEM) apparatus. For a region specified as the Al phase, the orientation ratio of the <100> crystal orientation of the Al phase in the RD direction can be calculated by using the analysis software attached to the apparatus. In calculating the orientation ratio, a partial ratio is used, the partial ratio being calculated by using, as a population, an area of only crystal orientations that have been identified based on certain reliability within a measurement area. Regarding the crystal orientation of the Al phase, the orientation ratio of the <100> crystal orientation in the RD direction is defined as an area ratio of the <100> crystal orientation in the RD direction. Thus, in one embodiment, the orientation ratio of the crystal orientation of the Al phase in the L cross-section of the Al bonding wire or the Al bonding ribbon according to the present invention is calculated through procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Al phase, the crystal orientation is analyzed, and the orientation ratio of the <100> crystal orientation in the RD direction is calculated.

In the procedure of (2) described above, setting of Tolerance (%) can be selected in a range from 20 to 40%, and about 30% is preferable for comparison in standard analysis of the L cross-section of the Al bonding wire or the Al bonding ribbon. The following supplementarily describes a procedure of adjusting the Tolerance. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, the orientation ratio of the <110> crystal orientation of the Al phase in the RD direction in the L cross-section is calculated as an average value (arithmetic mean) of respective values of the orientation ratios obtained by measuring at three or more parts. In selecting the measurement region, from a viewpoint of securing objectivity of measurement data, it is preferable to acquire a sample for measurement to be measured from the Al bonding wire or the Al bonding ribbon as a measurement target at intervals of 50 cm or more with respect to the center axis direction of the Al bonding wire or the Al bonding ribbon. In the present invention, the measurement region for the crystal orientation measured by the EBSD method is preferably determined so that the length in the center axis direction of the Al bonding wire or the Al bonding ribbon is equal to or larger than 300 μm and smaller than 800 μm, and the entire Al bonding wire or the entire Al bonding ribbon is accommodated therein in a direction perpendicular to the center axis of the Al bonding wire or the Al bonding ribbon, but if the size is large and the entire region is difficult to be measured, it can be adjusted in a range smaller than 600 μm.

-Distribution of equivalent circle diameter of Si phase in L cross-section-

From a viewpoint of obtaining excellent rapid temperature cycle reliability even in the rapid TCT with a large number of cycles, when Ns denotes the number of Si phases having an equivalent circle diameter equal to or larger than 0.5 μm and equal to or smaller than 0.8 μm in the L cross-section of the Al bonding wire or the Al bonding ribbon and Nc denotes the number of Si phases having an equivalent circle diameter equal to or larger than 0.5 μm in the L cross-section, a ratio of Ns to Nc [Ns/Nc × 100 (%)] (hereinafter, also referred to as a "small-diameter ratio of the Si phase") is equal to or larger than 30% and equal to or smaller than 95%. A lower limit of the ratio [Ns/Nc × 100 (%)] is preferably equal to or larger than 32%, equal to or larger than 35%, equal to or larger than 38%, equal to or larger than 40%, equal to or larger than 42%, or equal to or larger than 45%, more preferably equal to or larger than 48%, still more preferably equal to or larger than 50% or equal to or larger than 52%, and particularly preferably equal to or larger than 55% or equal to or larger than 60%. An upper limit of the ratio [Ns/Nc × 100 (%)] is preferably equal to or smaller than 92%, equal to or smaller than 90%, equal to or smaller than 88%, or equal to or smaller than 85%, more preferably equal to or smaller than 82% or equal to or smaller than 80%, still more preferably equal to or smaller than 78% or equal to or smaller than 75%, and particularly preferably equal to or smaller than 72% or equal to or smaller than 70%. In one embodiment, the ratio [Ns/Nc × 100 (%)] is preferably equal to or larger than 40% and equal to or smaller than 90%.

A reason why the ratio of the Si phase having an equivalent circle diameter equal to or larger than 0.5 μm and

equal to or smaller than 0.8 μm is important is considered as follows. That is, the Si phase having an equivalent circle diameter equal to or larger than 0.5 μm has a sufficiently large volume, so that an effect of reducing thermal expansion can be sufficiently obtained. In addition, from a viewpoint of analysis accuracy of current EDS and EBSD analysis apparatus, it is appropriate to target the Si phase having an equivalent circle diameter equal to or larger than 0.5 μm. On the other hand, in the Si phase having an equivalent circle diameter equal to or smaller than 0.8 μm, stress and distortion in the vicinity of the bonding interface caused by the Si phase become sufficiently uniform. Furthermore, a reason why excellent rapid temperature cycle reliability can be obtained even in the rapid TCT having a large number of cycles when a range of the small-diameter ratio of the Si phase [Ns/Nc × 100 (%)] is equal to or larger than 30% and equal to or smaller than 95% is considered as follows. That is, when the small-diameter ratio of the Si phase is equal to or larger than 30%, a sufficient number of Si phases having a small equivalent circle diameter are present, distribution of thermal distortion becomes uniform, and rapid temperature cycle reliability is stabilized. On the other hand, when the small-diameter ratio of the Si phase is equal to or smaller than 95%, a total volume of the Si phases increases, and an effect of reducing thermal expansion of an entire bonding region can be maintained at a high level, thereby making it possible to sufficiently increase an effect of improving rapid temperature cycle reliability.

Herein, each Si phase is formed in a particulate form, and it has been confirmed that the number of particles of the Si phase has a large influence on thermal distortion at the bonding interface. Therefore, rapid temperature cycle reliability can be evaluated by using a ratio of the number of particles of the Si phase. On the other hand, when an area of the particle is used, it is difficult to accurately evaluate correlation with rapid temperature cycle reliability since an influence of a coarse particle is excessively evaluated.

-Average diameter of Si phase in L cross-section-

In the Al bonding wire or the Al bonding ribbon according to the present invention, an average diameter of the Si phase in the L cross-section is preferably equal to or larger than 0.8 μm and equal to or smaller than 4.0 μm. The average diameter of the Si phase in the L cross-section of the Al bonding wire or the Al bonding ribbon according to the present invention is more preferably equal to or smaller than 3.8 μm or equal to or smaller than 3.5 μm, and still more preferably equal to or smaller than 3.4 μm, equal to or smaller than 3.2 μm, or equal to or smaller than 3.0 μm, and a lower limit thereof is more preferably equal to or larger than 1.0 μm or equal to or larger than 1.1 μm, and still more preferably equal to or larger than 1.2 μm or equal to or larger than 1.5 μm.

-Method for measuring equivalent circle diameter of Si phase and method for calculating small-diameter ratio-

The following describes a method for measuring an equivalent circle diameter of the Si phase in the L cross-section of the Al bonding wire or the Al bonding ribbon. The equivalent circle diameter of the Si phase in the L cross-section can be measured by using the SEM-EDS-EBSD apparatus. Specifically, similarly to measurement of the orientation ratio of the crystal orientation of the Al phase described above, a method of combining information of Al concentration and Si concentration obtained by the SEM-EDS and information of a crystal orientation obtained by the EBSD can be used. A more specific procedure is the same as that described above in relation to measurement of the orientation ratio of the crystal orientation of the Al phase, that is, the crystal orientation can be analyzed for a region specified as the Si phase by using the analysis software attached to the apparatus. If an orientation difference between measurement points is equal to or larger than 15°, it is determined to be a crystal grain boundary, and an equivalent circle diameter is calculated. The average diameter of the Si phase is defined as an average value of equivalent circle diameters of respective Si phases. In a process of obtaining the small-diameter ratio of the Si phase and the average diameter of the Si phase, calculation is performed excluding a part in which the crystal orientation cannot be measured, and a part in which the crystal orientation can be measured but reliability of orientation analysis is low. Thus, in one embodiment, the small-diameter ratio of the Si phase and the average diameter of the Si phase in the L cross-section of the Al bonding wire or the Al bonding ribbon according to the present invention is calculated through procedures from (1) to (3) as follows.

(1) The L cross-section of the Al bonding wire or the Al bonding ribbon is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. The number of crystal grains identified as the Si phase is counted to determine a total number Nc of particles of the Si phase. Herein, the Si phase having an equivalent circle

diameter equal to or larger than 0.5 μm is targeted. In consideration of analysis accuracy of current ESD and EBSD analysis apparatus, fine particles of less than 0.5 μm are excluded from the target. The number Ns of Si phases having an equivalent circle diameter equal to or larger than 0.5 μm and equal to or smaller than 0.8 μm is counted. The ratio of Ns to Nc [Ns/Nc × 100 (%)] (small-diameter ratio of the Si phase) is then calculated. An average of equivalent circle diameters of the respective crystal grains is calculated to obtain the average diameter of the Si phase. Herein, regarding average calculation, an average value obtained by Area average (area-weighted average), which can be selected by the software attached to the apparatus, is employed.

An example of measurement results is illustrated in FIG. 4. A horizontal axis indicates an equivalent circle diameter of the Si phase, each interval is illustrated with a width of 0.25 μm, and a vertical axis indicates the number of particles. A range equal to or larger than 0.5 μm and smaller than 0.8 μm is indicated by a double-headed arrow line, and a particle number ratio [Ns/Nc × 100 (%)] in these intervals is 50%. In a rapid temperature cycle test of this Al bonding wire, lowering of strength is suppressed to a low level even at 20,000 cycles, and it has been confirmed that rapid temperature cycle reliability is favorable.

-Crystal orientation of Si phase in L cross- section-

When bonding strength of a plurality of the Al bonding wires or Al bonding ribbons is evaluated in the rapid TCT, it has been confirmed that a plurality of bonding parts do not deteriorate at the same time, and variation occurs in deterioration of bonding strength. That is, even in a case in which the number of cycles of the rapid temperature cycle test increases and an average value of bonding strength is substantially maintained, variation occurs in deterioration of bonding strength as a result of lowering of the strength starting at bonding parts of a small number of the Al bonding wires or Al bonding ribbons. Even in a small number of the Al bonding wires or Al bonding ribbons, when deterioration of bonding strength progresses, a load on the other Al bonding wires or Al bonding ribbons increases at a high current, and there is a concern that a defect may rapidly occur. In achieving reliability required for the next-generation power semiconductor device, in the rapid TCT, not only management of a lifetime based on an average value of bonding strength but also control of variation in bonding strength are required.

From a viewpoint of obtaining further favorable rapid temperature cycle reliability and suppressing variation in bonding strength in the rapid TCT having a large number of cycles, when crystal orientations of the Si phase in the L cross-section of the Al bonding wire or the Al bonding ribbon are measured, a total of orientation ratios of a <100> crystal orientation and a <111> crystal orientation angled at 15° or less to a direction perpendicular to the center axis (ND direction, Normal Direction) (hereinafter, also referred to as "<100>+<111> total ratio of the Si phase in the ND direction") preferably falls within a range equal to or larger than 20% and equal to or smaller than 60%. In addition to the control of the orientation ratio of the <100> crystal orientation of the Al phase in the RD direction and the control of the small-diameter ratio of the Si phase described above, by setting the <100>+<111> total ratio of the Si phase in the ND direction to fall within such a range, local stress concentration is dispersed and spreading of a crack at the bonding interface is reduced, and as a result, variation in shear force after a severe rapid TCT of 20,000 cycles or more can be reduced. Furthermore, it is considered that, when the <100> crystal orientation and the <111> crystal orientation of the Si phase in the ND direction are aligned with the <100> crystal orientation of the Al phase in the RD direction, an effect of suppressing local peeling at the bonding interface is exhibited even when the number of cycles in the rapid TCT, in which a temperature changing speed is significant, increases. From a viewpoint of obtaining more excellent rapid temperature cycle reliability in the rapid TCT having a large number of cycles and from a viewpoint of suppressing variation in bonding strength in the rapid TCT having a large number of cycles, the <100>+<111> total ratio of the Si phase in the ND direction is more preferably equal to or larger than 25%, and still more preferably equal to or larger than 26%, equal to or larger than 28%, or equal to or larger than 30%. From a viewpoint of obtaining more excellent rapid temperature cycle reliability in the rapid TCT having a large number of cycles and from a viewpoint of suppressing variation in bonding strength in the rapid TCT having a large number of cycles, the <100>+<111> total ratio of the Si phase is more preferably equal to or smaller than 58%, and still more preferably equal to or smaller than 55%, equal to or smaller than 52%, equal to or smaller than 50%, equal to or smaller than 48%, or equal to or smaller than 45%.

(Method for measuring crystal orientation of Si phase)

The orientation ratio of the crystal orientation of the Si phase in the L cross-section of the Al bonding wire or the Al bonding ribbon can be measured by using a SEM-EDS-EBSD apparatus. Specifically, similarly to the measurement of the orientation ratio of the crystal orientation of the Al phase, a method of combining information of Al concentration and Si concentration obtained by the SEM-EDS and information of a crystal orientation obtained by the EBSD can be used. A more specific procedure may be the same as that described above in relation to measurement of the orientation ratio of the crystal orientation of the Al phase, that is, the orientation ratios of the <100> crystal orientation and the <111> crystal

orientation of the Si phase in the ND direction and a total thereof can be calculated for a region specified as the Si phase by using the analysis software attached to the apparatus. In calculating the orientation ratio, a partial ratio is used, the partial ratio being calculated by using, as a population, an area of only crystal orientations that have been identified based on certain reliability within a measurement area. Thus, in one embodiment, the orientation ratio of the crystal orientation of the Si phase in the L cross-section of the Al bonding wire or the Al bonding ribbon according to the present invention is calculated through procedures from (1) to (3) as follows.

(1) In the measurement region designating the L cross-section of the Al bonding wire or the Al bonding ribbon to be the inspection surface, measurement of concentration of Al and Si using the EDS and crystal orientation analysis using the EBSD are performed at the same time.
(2) Al and Si are separated and analyzed by using the Chi Scan function. Specifically, Al and Si can be separated and identified by setting Tolerance corresponding to a threshold of Si based on a measurement result of the EDS for Si. The crystal orientation is analyzed by using the crystal information of Al and Si in a material file.
(3) For the region that is specified as the Si phase, the crystal orientations are analyzed, and the orientation ratio of the <100> crystal orientation and the orientation ratio of the <111> crystal orientation of the Si phase in the ND direction are calculated.

In the present invention, the orientation ratio of the <100> crystal orientation and the orientation ratio of the <111> crystal orientation of the Si phase in the ND direction in the L cross-section are calculated as arithmetic mean values of respective values of the orientation ratios obtained by measuring at three or more parts. A setting range of Tolerance in the procedure of (2) described above, a method of acquiring a sample for measurement, and a measurement region of crystal orientation by the EBSD method are the same as those described above regarding measurement of the orientation ratio of the crystal orientation of the Al phase.

-Shape of Si phase in L cross-section-

When the Al bonding wire or the Al bonding ribbon is bonded to an electrode on a conductor chip or an electrode on a lead frame or a substrate, if a bonding defect such as peeling of the Al bonding wire or the Al bonding ribbon from the electrode occurs, it leads to a product defect or lowering of manufacturing yield, so that it is required to obtain favorable bonding strength at each bonding part. In this regard, at the 1st bonding part, when ultrasonic vibrations and/or loads are strongly applied to obtain favorable bonding strength, the semiconductor chip may be damaged. In particular, in a case of using the Al bonding wire or the Al bonding ribbon that is highly strengthened by adding Si and the like thereto, the semiconductor chip tends to be easily damaged at the time of 1st bonding due to hardness of the Al bonding wire or the Al bonding ribbon, and when ultrasonic vibrations and loads are adjusted to reduce such damage, sufficient bonding strength at the 1st bonding part (hereinafter, also simply referred to as "1st bonding strength") cannot be obtained in some cases because a bonding area cannot be stably secured due to high deformation resistance and instability of a deformation direction. Since these problems at the time of initial bonding of the 1st bonding part eventually become factors causing deterioration and/or instability of rapid temperature cycle reliability, it is more desirable that the Al bonding wire or the Al bonding ribbon that is highly strengthened by adding Si and the like thereto exhibits excellent 1st bonding strength.

Herein, the present inventors have found that, by controlling a shape of the Si phase (a ratio between a short side length e and a long side length f (e/f) of the Si phase in the L cross-section), adhesion in the center axis direction at an interface between the Si phase and the Al phase is improved, sliding at the interface when ultrasonic vibrations and loads are applied is controlled, and an effect of increasing initial shear force immediately after bonding (1st bonding strength) is obtained. As one of effects of increasing initial shear force, it is possible to obtain advantages such as stabilization of failure time (lifetime) in the rapid temperature cycle test.

Specifically, in a process of conducting studies on the Al bonding wire or the Al bonding ribbon containing 3.0% by mass or more and 20.0% by mass or less of Si, in which the <100> ratio of the Al phase in the RD direction in the L cross-section and the small-diameter ratio of the Si phase fall within specific ranges, the present inventors have found that the shape of the Si phase in the L cross-section influences the 1st bonding strength. In detail, the present inventors have found that, when an average value of the ratio between the short side length e and the long side length f (e/f) of the Si phase in the L cross-section falls within a range equal to or larger than 0.20 and equal to or smaller than 0.70, in addition to the effect of suppressing deterioration of bonding strength after the rapid TCT, the 1st bonding strength is improved, and eventually, variation in bonding strength is reduced. A numerical value of this ratio (e/f) is an index indicating flatness. Description will be further made with reference to FIG. 3. FIG. 3 is a diagram schematically illustrating the Si phase in the L cross-section of the Al bonding wire or the Al bonding ribbon so that the center axis direction of the Al bonding wire or the Al bonding ribbon corresponds to a horizontal direction (right and left direction) of FIG. 3, and a direction perpendicular to the center axis corresponds to a vertical direction (upper and lower direction) of FIG. 2. Regarding the Si phase in the L cross-section, the "short side length e" described above corresponds to a dimension indicated by a sign "e" in FIG. 3. Regarding the Si phase

in the L cross-section, the "long side length f" described above corresponds to a dimension indicated by a sign "f" in FIG. 3. Hereinafter, the ratio between the short side length e and the long side length f (e/f) of the Si phase in the L cross-section may also be referred to as a "shape ratio (e/f) of the Si phase". A numerical value of the shape ratio (e/f) of the Si phase can be obtained as Grain Shape Aspect Ratio by an analysis software attached to an apparatus.

In the Al bonding wire or the Al bonding ribbon according to the present invention, a reason why the 1st bonding strength can be improved by controlling the average value of the shape ratio (e/f) of the Si phase is estimated as follows. A factor causing reduction of the 1st bonding strength is that a crack develops inside the Al bonding wire or the Al bonding ribbon or at the bonding interface along the center axis direction of the Al bonding wire or the Al bonding ribbon or a direction close thereto. Herein, due to plastic processing by wire-drawing, the Si phase tends to be arranged such that a direction of the long side length f thereof becomes the center axis direction of the Al bonding wire or the Al bonding ribbon, or a direction close thereto. It is considered that, when the average value of the shape ratio (e/f) of the Si phase falls within a range equal to or larger than 0.20 and equal to or smaller than 0.70, the Si phase has a shape such as an ellipse or a column, an effect of relieving thermal stress in the center axis direction of the Al bonding wire or the Al bonding ribbon is exhibited, and eventually, it may be possible to suppress development of a crack along the center axis direction of the Al bonding wire or the Al bonding ribbon, or a direction close thereto. To improve the 1st bonding strength, it is sufficient that the average value of the shape ratio (e/f) of the Si phase in the L cross-section falls within the preferred range described above, and shape ratios (e/f) of all Si phases do not necessarily fall within the range equal to or larger than 0.20 and equal to or smaller than 0.70. For example, a Si phase having the shape ratio (e/f) smaller than 0.20 may be included, and/or a Si phase having the shape ratio (e/f) exceeding 0.70 may be included.

From a viewpoint of improving the 1st bonding strength, eventually reducing variation in bonding strength in the rapid TCT, and more favorably achieving reliability required for the next-generation power semiconductor device, the average value of the shape ratio (e/f) of the Si phase in the L cross-section of the Al bonding wire or the Al bonding ribbon according to the present invention is more preferably equal to or larger than 0.25, still more preferably equal to or larger than 0.30, and particularly preferably equal to or larger than 0.32, equal to or larger than 0.34, or equal to or larger than 0.35. From a viewpoint of improving the 1st bonding strength, an upper limit of the average value of the shape ratio (e/f) of the Si phase is more preferably equal to or smaller than 0.65 or equal to or smaller than 0.60, and still more preferably equal to or smaller than 0.58, equal to or smaller than 0.56, or equal to or smaller than 0.55.

-Method for measuring shape ratio (e/f) of Si phase-

The following describes a method for measuring the shape ratio (e/f) of the Si phase in the L cross-section of the Al bonding wire or the Al bonding ribbon. First, it can be measured by using the SEM-EDS-EBSD apparatus similarly to measurement of the crystal orientation and measurement of the equivalent circle diameter of the Si phase described above. Specifically, a method of combining information of Al concentration and Si concentration obtained by the SEM-EDS and information of a crystal orientation obtained by the EBSD can be used. A more specific procedure is the same as that described above in relation to measurement of the orientation ratio of the crystal orientation, that is, the crystal orientation can be analyzed for a region specified as the Si phase by using the analysis software attached to the apparatus. If an orientation difference between measurement points is equal to or larger than 15°, it is determined to be a crystal grain boundary, and the shape ratio (e/f) is calculated. The average value of the shape ratio (e/f) of the Si phase is defined as an average value of shape ratios (e/f) of the respective Si phases. In a process of obtaining the shape ratio (e/f) of the Si phase, calculation is performed excluding a part in which the crystal orientation cannot be measured, and a part in which the crystal orientation can be measured but reliability of orientation analysis is low. Thus, in one embodiment, the average value of the shape ratio (e/f) of the Si phase in the L cross-section of the Al bonding wire or the Al bonding ribbon according to the present invention is calculated through procedures from (1) to (3) as follows.

(1) The L cross-section of the Al bonding wire or the Al bonding ribbon is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Si phase, the crystal orientation is analyzed, and if the orientation difference between measurement points is equal to or larger than 15°, it is determined to be the crystal grain boundary and the shape ratios (e/f) of respective crystal grains are obtained, and an average of the shape ratios (e/f) of the respective crystal grains is calculated to obtain the average value of the shape ratio (e/f) of the Si phase. Herein, as the average value of the shape ratio (e/f) of the Si phase, a numerical value of Grain Shape Aspect Ratio of the analysis software (hereinafter, referred to as a "grain shape aspect ratio") is used. This numerical value is an average value obtained by calculating an average of grain shape aspect ratios of the respective crystal grains. Regarding a method for calculating

the grain shape aspect ratio, a ratio (e/f) between a short side length (e) (Grain Shape Minor Axis) and a long side length (f) (Grain Shape Major Axis) of one crystal grain is obtained. Regarding average calculation, an average value obtained by Area average (area-weighted average), which can be selected by the software attached to the apparatus, is employed. By employing the average value obtained by Area average, it is possible to accurately measure and determine whether a condition is met, the condition being related to the average value of the shape ratio (e/f) of the Si phase, which is suitable for reducing variation in bonding strength in the rapid temperature cycle test having a large number of cycles and more favorably achieving rapid temperature cycle reliability required for the next-generation power semiconductor device.

In measuring the average value of the shape ratio (e/f) of the Si phase in the L cross-section, a setting range of Tolerance in the procedure of (2) described above and a measurement region of crystal orientation by the EBSD method are the same as those described above regarding measurement of the orientation ratio of the crystal orientation of the Al phase.

Examples of the method for measuring the equivalent circle diameter of the Si phase and the shape ratio (e/f) of the Si phase include several methods including binarization processing from an observation image of the L cross-section in addition to the methods described above. The present invention preferably uses the method of combining information of Al concentration and Si concentration obtained by the SEM-EDS and information of crystal orientation obtained by the EBSD as described above because many measuring functions are provided and a plurality of characteristics such as the crystal orientation, the equivalent circle diameter of the Si phase, and the shape ratio (e/f) of the Si phase described above can be obtained by one time of measurement, automatic analysis can be performed, and measurement can be easily performed with a widespread apparatus and analysis technique.

-Addition of Sr, Na, Fe, and P-

The Al bonding wire or the Al bonding ribbon according to the present invention may further contain one or more of Sr, Na, Fe, and P (hereinafter, also referred to as a "first element group"). A total concentration of the first element group may be 0 mass ppm, preferably equal to or larger than 1 mass ppm, more preferably equal to or larger than 3 mass ppm, still more preferably equal to or larger than 5 mass ppm, and particularly preferably equal to or larger than 8 mass ppm or equal to or larger than 10 mass ppm. An upper limit of the total concentration of the first element group is preferably equal to or smaller than 10000 mass ppm or equal to or smaller than 8000 mass ppm, more preferably equal to or smaller than 5000 mass ppm or equal to or smaller than 3000 mass ppm, still more preferably equal to or smaller than 2000 mass ppm or equal to or smaller than 1000 mass ppm, and particularly preferably equal to or smaller than 900 mass ppm or equal to or smaller than 800 mass ppm. In one embodiment, the total concentration of the first element group is preferably equal to or larger than 10 mass ppm and equal to or smaller than 800 mass ppm.

When the Al bonding wire or the Al bonding ribbon according to the present invention further contains 10 mass ppm or more and 800 mass ppm or less of one or more of Sr, Na, Fe, and P in total, a generation frequency of wire breakage can be reduced in wire-drawing processing for the Al bonding wire or the Al bonding ribbon. In an Al alloy containing a high concentration of Si equal to or larger than 3.0% by mass and equal to or smaller than 20.0% by mass, a frequency of wire breakage at a wire-drawing step tends to be increased. This may be because particles of the Si phase crystallized at the time of solidification cause stress concentration during the wire-drawing processing, and induce wire breakage. It is estimated that stress concentration during wire-drawing can be relieved and wire breakage can be reduced due to effects such that the particulate Si phase may be uniformly distributed and/or growth and coarsening of the Si phase may be suppressed by adding the first element group. It is considered that an effect of relieving stress concentration during wire-drawing can be enhanced by controlling the orientation ratio of the crystal orientation of the Al phase in the RD direction and the small-diameter ratio of the Si phase in the L cross-section and adding the first element group thereto.

From a viewpoint of reducing the generation frequency of wire breakage in the wire-drawing processing, the total concentration of the first element group in the Al bonding wire or the Al bonding ribbon according to the present invention is more preferably equal to or larger than 20 mass ppm, and still more preferably equal to or larger than 30 mass ppm, equal to or larger than 40 mass ppm, or equal to or larger than 50 mass ppm, and an upper limit thereof is preferably equal to or smaller than 750 mass ppm, more preferably equal to or smaller than 740 mass ppm, equal to or smaller than 720 mass ppm, or equal to or smaller than 700 mass ppm, still more preferably equal to or smaller than 680 mass ppm, equal to or smaller than 650 mass ppm, equal to or smaller than 620 mass ppm, or equal to or smaller than 600 mass ppm, and particularly preferably equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains one or more elements of the first element group, it may contain any one element of the first element group, may contain any two elements of the first element group, may contain any three elements of the first element group, or may contain all of four elements of the first element group. In a case in which the Al bonding wire or the Al bonding ribbon according to the present

invention contains one or more elements of the first element group, it may contain Sr, may contain Na, may contain Fe, and/or may contain P.

In a case in which the Al bonding wire or the Al bonding ribbon according to the present invention contains Sr of the first element group, a concentration of Sr may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Sr is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Sr is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Sr is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Na of the first element group, a concentration of Na may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Na is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Na is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Na is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Fe of the first element group, a concentration of Fe may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Fe is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Fe is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Fe is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains P of the first element group, a concentration of P may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of P is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of P is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of P is more preferably equal to or smaller than 800 mass ppm, and still more preferably equal to or smaller than 750 mass ppm, equal to or smaller than 740 mass

ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

-Addition of Ti, Ni, Mg, and Cu-

The Al bonding wire or the Al bonding ribbon according to the present invention may further contain one or more of Ti, Ni, Mg, and Cu (hereinafter, also referred to as a "second element group"). A total concentration of the second element group may be 0 mass ppm, preferably equal to or larger than 1 mass ppm or equal to or larger than 3 mass ppm, more preferably equal to or larger than 5 mass ppm or equal to or larger than 8 mass ppm, still more preferably equal to or larger than 10 mass ppm or equal to or larger than 30 mass ppm, and particularly preferably equal to or larger than 50 mass ppm, equal to or larger than 80 mass ppm, or equal to or larger than 100 mass ppm. An upper limit of the total concentration of the second element group is preferably equal to or smaller than 10000 mass ppm, more preferably equal to or smaller than 8000 mass ppm, still more preferably equal to or smaller than 5000 mass ppm, and particularly preferably equal to or smaller than 3000 mass ppm or equal to or smaller than 2000 mass ppm. In one embodiment, the total concentration of the second element group is preferably equal to or larger than 100 mass ppm and equal to or smaller than 2000 mass ppm.

When the Al bonding wire or the Al bonding ribbon according to the present invention further contains 100 mass ppm or more and 2000 mass ppm or less of one or more of Ti, Ni, Mg, and Cu in total, generation of scratches and scrapes on the surface of the Al bonding wire or the Al bonding ribbon can be suppressed, and a smooth surface can be formed. In an Al alloy containing a high concentration of Si equal to or larger than 3.0% by mass and equal to or smaller than 20.0% by mass, scratches and/or scrapes may be generated on a surface thereof during the wire-drawing processing, and may result in the Al bonding wire or the Al bonding ribbon with large surface unevenness when the surface is hardened and/or the Si phase and Al oxide present on the surface are dropped. It is estimated that scratches and scrapes during the wire-drawing processing can be reduced by adding the second element group to accelerate stabilization of the Al oxide on the surface of the Al bonding wire or the Al bonding ribbon, refinement and hardening of structures of Al crystal grains, and the like. It is considered that an effect of suppressing generation of scratches and scrapes on the surface of the Al bonding wire or the Al bonding ribbon to form a smooth surface can be enhanced by controlling the orientation ratio of the crystal orientation of the Al phase in the RD direction and the small-diameter ratio of the Si phase in the L cross-section and adding the second element group thereto.

From a viewpoint of suppressing generation of scratches and scrapes on the surface to form the Al bonding wire or the Al bonding ribbon having a smooth surface, the total concentration of the second element group in the Al bonding wire or the Al bonding ribbon according to the present invention is more preferably equal to or larger than 150 mass ppm, and still more preferably equal to or larger than 200 mass ppm, equal to or larger than 250 mass ppm, or equal to or larger than 300 mass ppm, and an upper limit thereof is preferably equal to or smaller than 1800 mass ppm, more preferably equal to or smaller than 1600 mass ppm, equal to or smaller than 1500 mass ppm, or equal to or smaller than 1200 mass ppm, still more preferably equal to or smaller than 1000 mass ppm, equal to or smaller than 900 mass ppm, or equal to or smaller than 800 mass ppm, and particularly preferably equal to or smaller than 700 mass ppm, equal to or smaller than 600 mass ppm, or equal to or smaller than 500 mass ppm.

In a case in which the Al bonding wire or the Al bonding ribbon according to the present invention contains one or more elements of the second element group, it may contain any one element of the second element group, may contain any two elements of the second element group, may contain any three elements of the second element group, or may contain all of four elements of the second element group. In a case in which the Al bonding wire or the Al bonding ribbon according to the present invention contains one or more elements of the second element group, it may contain Ti, may contain Ni, may contain Mg, and/or may contain Cu.

In a case in which the Al bonding wire or the Al bonding ribbon according to the present invention contains Ti of the second element group, a concentration of Ti may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ti is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ti is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ti is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than

1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Ni of the second element group, a concentration of Ni may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ni is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ni is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ni is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Mg of the second element group, a concentration of Mg may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Mg is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Mg is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Mg is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Cu of the second element group, a concentration of Cu may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Cu is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Cu is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Cu is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

As an aluminum raw material for manufacturing the Al bonding wire or the Al bonding ribbon according to the present invention, it is preferable to use Al having a purity of 4N (Al: 99.99% by mass or more), and more preferable to use Al having a purity of 5N (Al: 99.999% by mass or more) in which an amount of impurities is smaller. In one embodiment, Al having a purity of 3N (Al: 99.9% by mass or more) may be used.

In a range of not inhibiting the effect of the present invention, the Al bonding wire or the Al bonding ribbon according to the present invention may further contain elements other than Al, Si, the first element group, and the second element group (hereinafter, also referred to as "other elements"). That is, the "other elements" mean elements other than Al, Si, Sr, Na, Fe, P, Ti, Ni, Mg, and Cu, and the Al bonding wire or the Al bonding ribbon according to the present invention may further contain elements other than Al, Si, Sr, Na, Fe, P, Ti, Ni, Mg, and Cu. A total concentration of the other elements in the Al bonding wire or the Al bonding ribbon is not particularly limited in a range of not inhibiting the effect of the present

invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al bonding wire or the Al bonding ribbon according to the present invention consists of Al and other elements. Thus, according to a preferred embodiment, the Al bonding wire or the Al bonding ribbon according to the present invention consists of Al, Si, and other elements. According to another preferred embodiment, the Al bonding wire or the Al bonding ribbon according to the present invention consists of Al, Si, one or more elements of the first element group, and other elements. According to yet another preferred embodiment, the Al bonding wire or the Al bonding ribbon according to the present invention consists of Al, Si, one or more elements of the second element group, and other elements. According to yet another preferred embodiment, the Al bonding wire or the Al bonding ribbon according to the present invention consists of Al, Si, one or more elements of the first element group, one or more elements of the second element group, and other elements.

According to one embodiment, a balance of the Al bonding wire or the Al bonding ribbon according to the present invention consists of Al and inevitable impurities. Thus, according to a preferred embodiment, the Al bonding wire or the Al bonding ribbon according to the present invention consists of Al, Si, and inevitable impurities. According to another preferred embodiment, the Al bonding wire or the Al bonding ribbon according to the present invention consists of Al, Si, one or more elements of the first element group, and inevitable impurities. According to yet another preferred embodiment, the Al bonding wire or the Al bonding ribbon according to the present invention consists of Al, Si, one or more elements of the second element group, and inevitable impurities. According to yet another preferred embodiment, the Al bonding wire or the Al bonding ribbon according to the present invention consists of Al, Si, one or more elements of the first element group, one or more elements of the second element group, and inevitable impurities.

According to a preferred embodiment, the Al bonding wire or the Al bonding ribbon according to the present invention does not have a coating that contains a metal other than Al as a main component on an outer periphery of the Al bonding wire or the Al bonding ribbon. Herein, the "coating that contains a metal other than Al as a main component" means the coating in which the content of the metal other than Al is 50% by mass or more.

The Al bonding wire or the Al bonding ribbon according to the present invention may be an Al bonding wire, and may be an Al bonding ribbon. In a case in which the present invention is the Al bonding wire, a wire diameter thereof is not particularly limited, and may be equal to or larger than 50 μm, equal to or larger than 60 μm, equal to or larger than 80 μm, equal to or larger than 100 μm, equal to or larger than 120 μm, equal to or larger than 140 μm, equal to or larger than 150 μm, equal to or larger than 180 μm, or equal to or larger than 200 μm, for example. An upper limit of the wire diameter is not particularly limited, and may be equal to or smaller than 600 μm, equal to or smaller than 550 μm, equal to or smaller than 500 μm, equal to or smaller than 450 μm, or equal to or smaller than 400 μm, for example. In one embodiment, the wire diameter of the Al bonding wire according to the present invention may fall within a range from 100 to 600 μm, and preferably falls within a range from 200 to 400 μm. In a case in which the present invention is the Al bonding ribbon, dimensions (width W × thickness T) of a cross section having a rectangular shape or a substantially rectangular shape are not particularly limited, for example, W may be 100 to 3000 μm and T may be 50 to 600 μm.

The Al bonding wire or the Al bonding ribbon according to the present invention can exhibit excellent rapid temperature cycle reliability even in the rapid temperature cycle test with a large number of cycles. Thus, the Al bonding wire or the Al bonding ribbon according to the present invention can be preferably used as an Al bonding wire or an Al bonding ribbon for a semiconductor device. Particularly, the Al bonding wire or the Al bonding ribbon according to the present invention can be preferably used as an Al bonding wire or an Al bonding ribbon for a power semiconductor device, and can be more preferably used as an Al bonding wire or an Al bonding ribbon for a SiC power semiconductor device.

-Method for manufacturing Al bonding wire or Al bonding ribbon-

The following describes an example of a method for manufacturing the Al bonding wire or the Al bonding ribbon according to the present invention. The following describes an example of manufacture of the Al bonding wire.

Al and alloy elements as raw materials preferably have a high purity. Al preferably has a purity of 99.5% by mass or more and includes inevitable impurities as a balance, more preferably has a purity of 99.9% by mass or more and includes inevitable impurities as a balance, and still more preferably has a purity of 99.99% by mass or more and includes inevitable impurities as a balance. Si, the first element group, the second element group, and other elements used as alloy elements preferably have a purity of 99.9% by mass or more and include inevitable impurities as a balance, and more preferably have a purity of 99.99% by mass or more and include inevitable impurities as a balance. An Al alloy used for the

Al bonding wire can be manufactured by loading an Al raw material and raw materials for alloy elements into a crucible made of graphite or alumina that is processed to obtain an ingot having a cylindrical shape, and melting the raw materials by using an electric furnace or a high-frequency heating furnace. A diameter of the ingot having a cylindrical shape is preferably equal to or larger than Φ6 mm and smaller than Φ8 mm while considering processability at a subsequent processing step. An atmosphere in the furnace at the time of melting is preferably an inert atmosphere or a reducing atmosphere to prevent Al, Si, the first element group, the second element group, and other elements constituting the wire from being excessively oxidized. The highest end-point temperature of melted metal at the time of melting preferably falls within a range equal to or higher than 800°C and lower than 1050°C, considering to facilitate control of the shape and the size of the Si phase at the time of solidification and the like while securing fluidity of the melted metal. As a method for cooling after the melting, water cooling, furnace cooling, air cooling, and the like can be used.

By performing solution treatment to heat the ingot having a cylindrical shape obtained by melting at a high temperature, and repeatedly performing wire-drawing processing using dies thereon, the wire having a desired wire diameter can be manufactured. The wire after being subjected to the wire-drawing processing can be used as an Al bonding wire by performing final heat treatment using the electric furnace.

To control the crystal orientation of the Al phase, the small-diameter ratio of the Si phase, the average diameter of the Si phase and the crystal orientation of the Si phase in the L cross-section, it is effective to control a heat treatment condition for solution treatment, homogenization processing, final heat treatment, and/or the like, and a wire-drawing processing condition, and the like. At the time of wire-drawing processing, it is effective to use a lubricating liquid to secure lubricity at a contact interface between the wire and the die.

The following describes an example of a manufacturing condition for controlling the orientation ratio of the <100> crystal orientation of the Al phase in the RD direction in the L cross-section to fall within a range equal to or larger than 15% and equal to or smaller than 50%, and controlling the small-diameter ratio of the Si phase to fall within a range equal to or larger than 30% and equal to or smaller than 95%.

<Control of <100> crystal orientation of Al phase in RD direction>

Regarding the wire-drawing processing condition, it is effective to set an area reduction ratio of the wire per die used at the time of wire-drawing processing to fall within a range equal to or larger than 10% and smaller than 20%. Herein, defining that the area reduction ratio of the wire per die is P1, P1 is represented by the following equation.

$$P1 = \{(R_2^2 - R_1^2)/R_2^2\} \times 100$$

In the equation, $R_2$ represents a diameter (mm) of the wire before processing, and $R_1$ represents a diameter (mm) of the wire after processing.

By controlling processing distortion by adjusting an average value of an area reduction ratio of a die to fall within a range equal to or larger than 10% and smaller than 20%, it is possible to adjust the <100> crystal orientation of the Al phase in the RD direction. For example, increasing processing distortion by increasing the area reduction ratio is useful for controlling the ratio of the <100> crystal orientation of the Al phase in the RD direction, which is a recrystallized structure, when heat treatment is applied.

When a condition for the intermediate heat treatment is adjusted, adjustment of the orientation ratio of the <100> crystal orientation of the Al phase in the RD direction is facilitated. The intermediate heat treatment is heat treatment that is performed in the intermediate of a step of processing the ingot until the final wire diameter is obtained. The number of times of the intermediate heat treatment preferably falls within a range from 3 to 4, and a wire diameter to be subjected to the intermediate heat treatment is selectable. Among these, performing intermediate heat treatment (intermediate annealing) at least once within a wire diameter range of 4.0 to 5.5 times the final wire diameter and at least once within a wire diameter range of 2.0 to 3.5 times the final wire diameter, the intermediate heat treatment being performed at a temperature range equal to or higher than 250°C and lower than 400°C and for a time equal to or longer than 1 hour and shorter than 48 hours, is useful for adjusting the orientation ratio of the <100> crystal orientation of the Al phase in the RD direction at the final wire diameter to fall within a range equal to or larger than 15% and equal to or smaller than 50%. By performing the intermediate heat treatment under this condition, processing distortion of the Al phase is reduced and slight recrystallization is caused, thereby reducing a worked structure of the Al phase at the final wire diameter, increasing a degree of progress of recrystallization of the Al phase in subsequent heat treatment, and accelerating rotation of the crystal orientation, whereby adjustment of the orientation ratio of the <100> crystal orientation of the Al phase in the RD direction is facilitated. On the other hand, when the intermediate heat treatment temperature is equal to or higher than 400°C, there is a concern that the orientation ratio of the <100> crystal orientation of the Al phase in the RD direction becomes unstable.

<Control of small-diameter ratio of Si phase>

Optimizing an intermediate heat treatment condition and a final heat treatment condition as a set is effective for controlling the small-diameter ratio of the Si phase. Specifically, defining Tm (°C) as a temperature of the intermediate heat treatment at a wire diameter closest to the final wire diameter (the last intermediate heat treatment) and Tc (°C) as a temperature of the final heat treatment at the final wire diameter, when the temperature Tm of the intermediate heat treatment is higher than the temperature Tc of the final heat treatment by 50°C or more, it becomes easy to adjust the small-diameter ratio of the Si phase to be equal to or larger than 30% and equal to or smaller than 95%. Specifically, by increasing the intermediate heat treatment temperature, Si dissolved in the Al phase as a solid solution can be homogenized, and by lowering the temperature of a final heat treatment step, a solid solution concentration of Si in the Al phase can be reduced. By a combination of these temperatures, the number of fine Si phases can be increased, and the small-diameter ratio of the Si phase can be increased. Among a plurality of the intermediate heat treatments, adjusting the temperature of the last intermediate heat treatment is more effective, and it is considered that the number of fine Si phases can be increased by utilizing dislocations and the like increased at a subsequent processing step.

As the final heat treatment condition, it is effective to adjust a temperature range to be equal to or higher than 200°C and lower than 360°C, and adjust a time within a range equal to or longer than 2 hours and shorter than 20 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment, the small-diameter ratio of the Si phase can be easily controlled. For example, by adjusting the final heat treatment to be performed at a low temperature or in a short time, the small-diameter ratio of the Si phase tends to increase. Furthermore, by adjusting the final heat treatment condition, it also becomes easy to control an average value of the equivalent circle diameter of the Si phase (an average diameter of the Si phase).

<Control of shape ratio (e/f) of Si phase>

To adjust the shape ratio (e/f) of the Si phase in the L cross-section, it is effective to control conditions for the two-step heat treatment (solution treatment and homogenization processing) and the final heat treatment described above.

It is preferable that a temperature range of solution treatment for the ingot is equal to or higher than 400°C and lower than 550°C and a time therefor is equal to or longer than 1 hour and shorter than 6 hours, and that a temperature range of subsequent homogenization processing is equal to or higher than 250°C and lower than 350°C and a time therefor is equal to or longer than 2 hours and shorter than 6 hours. Through the solution treatment, fragmentation and growth of the Si phase crystallized in a solidification process occur, and through the homogenization processing, dissolution and precipitation of Si occur at an interface of the Si phase, whereby the shape of the Si phase can be controlled. For example, when solution treatment is performed at a high temperature, the shape ratio (e/f) of the Si phase tends to be reduced.

<Control of crystal orientation of Si phase in ND direction>

To adjust the crystal orientation of the Si phase in the ND direction, it is effective to perform two-step heat treatment (solution treatment and homogenization processing) on the ingot and to control an area reduction ratio in wire-drawing processing.

It is effective to set a temperature range for the solution treatment to be equal to or higher than 450°C and lower than 550°C, and set a time therefor to be equal to or longer than 1 hour and shorter than 6 hours. After this solution treatment, it is effective to perform homogenization processing at a temperature equal to or higher than 250°C and lower than 350°C and for a time equal to or longer than 2 hours and shorter than 6 hours. Accordingly, fragmentation and growth of the Si phase crystallized in the solidification process can be accelerated, and for the crystal orientation of the Si phase in the ND direction, alignment of the <100> crystal orientation and the <111> crystal orientation can be adjusted.

It is also effective to control the alignment of the crystal orientation of the Si phase by incorporating, into the wire-drawing step, wire drawing having an area reduction ratio of a die falling within a range larger than 20% and smaller than 30%, which is a high area reduction ratio, thereby increasing processing distortion. In a case of providing two or more wire-drawing steps, it is sufficient that the area reduction ratio of the die is larger than 20% and smaller than 30% in at least one wire-drawing step. By adjusting the area reduction ratio of the wire within the above-described range, the entire Al bonding wire or Al bonding ribbon can be greatly deformed at the time of die processing, and processing distortion can be increased to an inner part of the Al bonding wire or the Al bonding ribbon. The Si phase is arranged in the center axis direction of the Al bonding wire or the Al bonding ribbon, and at the same time, processing distortion in the Si phase is adjusted. Even in a case in which it is not easy to adjust the crystal orientation of the Si phase only by performing the two-step heat treatment (solution treatment and homogenization processing) for the ingot described above, it becomes possible to adjust the orientation ratios of the <100> crystal orientation and the <111> crystal orientation of the Si phase in the ND direction by

also incorporating adjustment of the area reduction ratio of the die within the range described above.

Earlier mentioned, as a representative example of the Al bonding wire or the Al bonding ribbon, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

[Semiconductor device]

The semiconductor device can be manufactured by connecting the electrode on the semiconductor chip to the lead frame or an external electrode on the substrate by using the Al bonding wire or the Al bonding ribbon according to the present invention. That is, the semiconductor device according to the present invention comprises the Al bonding wire or the Al bonding ribbon according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention comprises a circuit board, the semiconductor chip, and the Al bonding wire or the Al bonding ribbon for bringing the circuit board and the semiconductor chip into conduction with each other, and is characterized in that the Al bonding wire or the Al bonding ribbon is the Al bonding wire or the Al bonding ribbon according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may comprise a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

[Examples]

Hereinafter, the present invention will be described in detail with reference to Examples. However, the present invention is not limited to the following Examples.

(Sample)

A method for producing a sample will be described. As a raw material, Al having a purity of 4N (99.99% by mass or more) and including inevitable impurities as a balance was used. Si, the first element group (Sr, Na, Fe, P), the second element group (Ti, Ni, Mg, Cu), and other elements (Mn, Zn) used as alloy elements each having a purity of 99.99% by mass or more and including inevitable impurities as a balance were also used. The Al alloy used for the Al bonding wire or the Al bonding ribbon was manufactured by loading an Al raw material and raw materials for the alloy elements into an alumina crucible, and melting them by using a high-frequency heating furnace. An atmosphere inside the furnace at the time of melting was an Ar atmosphere, and the highest end-point temperature of melted metal at the time of melting was set to be equal to or higher than 800°C and lower than 1050°C. The cooling method after the melting was air cooling for performing cooling in the air, or water cooling for performing cooling in water.

After an ingot of Φ6 mm having a cylindrical shape was obtained by melting, and the ingot was subjected to solution treatment and homogenization processing, wire-drawing processing using dies and intermediate heat treatment were performed to produce an Al bonding wire of Φ300 μm. By using the Al bonding wire of Φ300 μm as a starting material, an Al bonding ribbon having a thickness of 100 μm and a width of 600 μm was manufactured by two-step rolling. A temperature range for the solution treatment was set to be equal to or higher than 500°C and lower than 550°C, and a time therefor was set to be equal to or longer than 2 hours and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 2 hours and shorter than 5 hours. The cooling method after the homogenization processing was air cooling for performing cooling in the air.

The intermediate heat treatment was performed three to four times. Regarding the wire diameter after the intermediate heat treatment relative to the final wire diameter, first intermediate annealing was performed at a wire diameter in a range from 6.5 to 7.0 times, second intermediate annealing was performed at a wire diameter in a range from

4.0 to 5.0 times, and third intermediate annealing was performed at a wire diameter in a range from 2.0 to 3.0 times, respectively. In a case in which the intermediate heat treatment was performed four times, the intermediate annealing was performed at a wire diameter in a range from 7.5 to 8.5 times the final wire diameter. A temperature range for the intermediate heat treatment was adjusted such that, for the first and second intermediate heat treatments, the temperature was equal to or higher than 300°C and lower than 370°C and a time was equal to or longer than 1 hour and shorter than 3 hours, and for the third and fourth intermediate heat treatments, the temperature was equal to or higher than 250°C and lower than 400°C and the time was equal to or longer than 2 hours and shorter than 40 hours.

A commercially available lubricating liquid was used at the time of the wire-drawing processing, and an area reduction ratio of the wire per die at the time of the wire-drawing processing was equal to or larger than 10.0% and smaller than 30.0%. The area reduction ratio of the wire was adjusted in accordance with a diameter of the die. A temperature range for the final heat treatment was set to be equal to or higher than 200°C and lower than 350°C, and a time for the final heat treatment was set to be equal to or longer than 2 hours and shorter than 20 hours. The temperature (Tc) of the final heat treatment was selected in a temperature range lower than the temperature (Tm) of the third or fourth intermediate annealing described above by 50 to 100°C.

In some examples, the wire-drawing processing was performed using dies having a die angle equal to or larger than 14° and smaller than 18°.

(Method for measuring element content)

For concentration analysis of elements contained in the Al bonding wire or the Al bonding ribbon, Inductively Coupled Plasma-Optical Emission Spectrometer (ICP-OES) ("PS3520UVDDII" manufactured by Hitachi High-Tech Science Corporation) or Inductively Coupled Plasma-Mass Spectrometer (ICP-MS) ("Agilent 7700x ICP-MS" manufactured by Agilent Technologies, Inc.) was used as an analysis apparatus.

(Method for measuring orientation ratios of crystal orientations of Al phase and Si phase)

The L cross-section (cross section in the center axis direction including the center axis) of the Al bonding wire or the Al bonding ribbon was designated as the inspection surface, and the crystal orientations of the Al phase and the Si phase were measured.

An FE-SEM (SU-70 manufactured by Hitachi High-Tech Corporation) was used for measurement, and APEX (for data collection) manufactured by TSL solutions KK, OIM Data Collection (for Chi Scan), and OIM Analysis (for data analysis) were used as analysis software. Measurement regions at three parts were randomly selected at intervals of 50 cm or more with respect to the center axis direction of the Al bonding wire or the Al bonding ribbon, and the regions at the three parts were measured. The measurement region was determined so that a size thereof in the center axis direction of the Al bonding wire or the Al bonding ribbon was equal to or larger than 300 μm and smaller than 800 μm, and the entire Al bonding wire or Al bonding ribbon was accommodated therein in the direction perpendicular to the center axis. As a main condition for EDS and EBSD measurement, an acceleration voltage was set to be 15 kV, a measurement magnification was set to be 350-fold, a scan speed was set to be 30 to 120 points/second, and a measurement interval was set to fall within a range from 0.1 to 0.3 μm. Herein, if the scan speed is high, the measurement time can be shortened, but there is concern that measurement accuracy of the EDS may be lowered. It is preferable to select an appropriate scan speed in the range described above.

-Crystal orientation of Al phase-

In measuring the orientation ratio of the crystal orientation of the Al phase in the L cross-section of the Al bonding wire or the Al bonding ribbon, the SEM-EDS-EBSD apparatus was used, and a method of combining information of Al concentration and Si concentration obtained by the SEM-EDS and information of a crystal orientation obtained by the EBSD was used. Specifically, measurement was performed in accordance with procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD were performed at the same time.

(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si in the material file was used for analyzing the crystal orientation. Herein, a condition for Tolerance was mainly set to be 30%, and adjusted as needed.

(3) For the region that was specified as the Al phase, the crystal orientation was analyzed, and the orientation ratio of the <100> crystal orientation of the Al phase in the RD direction was calculated. As crystal orientations to be

investigated, at least three types of <111>, <110>, and <100>, which are representative crystal orientations of Al metal, were selected, and crystal orientations having high ratios were selected as needed. Herein, as the orientation ratio of the crystal orientation, a partial ratio was used.

The orientation ratio of the <100> crystal orientation of the Al phase in the RD direction was calculated as an average value (arithmetic mean) of respective values obtained for measurement regions at three parts through the procedures from (1) to (3) described above.

-Crystal orientation of Si phase-

In measuring the orientation ratio of the crystal orientation of the Si phase in the L cross-section of the Al bonding wire or the Al bonding ribbon, similarly to measurement of the orientation ratio of the crystal orientation of the Al phase, the SEM-EDS-EBSD apparatus was used, and a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows. (3) For the region that was specified as the Si phase, the crystal orientations were analyzed, and the orientation ratio of the <100> crystal orientation and the orientation ratio of the <111> crystal orientation of the Si phase in the ND direction were calculated. As the orientation ratio of the crystal orientation, a partial ratio was used.

The orientation ratio of the <100> crystal orientation and the orientation ratio of the <111> crystal orientation of the Si phase in the ND direction were calculated as average values (arithmetic means) of respective values obtained for measurement regions at three parts through the procedures from (1) to (3) described above.

(Small-diameter ratio of Si phase [Ns/Nc × 100 (%)])

In measuring the small-diameter ratio of the Si phase [Ns/Nc × 100 (%)] in the L cross-section, similarly to measurement of the orientation ratio of the crystal orientation of the Al phase, the SEM-EDS-EBSD apparatus was used, and a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows. (3) For the region that was specified as the Si phase, the crystal orientation was analyzed, and if the orientation difference between measurement points was equal to or larger than 15°, it was determined to be the crystal grain boundary, and the equivalent circle diameter of each crystal grain was obtained. The number of crystal grains identified as the Si phase was counted to determine a total number Nc of particles of the Si phase. Herein, the Si phase having an equivalent circle diameter equal to or larger than 0.5 μm was targeted. In consideration of analysis accuracy of current EDS and EBSD analysis apparatus, fine particles smaller than 0.5 μm were excluded from the target. Subsequently, the number Ns of Si phases having an equivalent circle diameter equal to or larger than 0.5 μm and equal to or smaller than 0.8 μm was counted. The ratio of Ns to Nc [Ns/Nc × 100 (%)] (small-diameter ratio of the Si phase) was then calculated.

The small-diameter ratio of the Si phase was calculated as an average value (arithmetic mean) of respective values obtained for measurement regions at three parts through the procedures from (1) to (3) described above.

(Method for measuring average diameter of Si phase)

In measuring the average diameter of the Si phase in the L cross-section of the Al bonding wire or the Al bonding ribbon, similarly to measurement of the crystal orientation of the Al phase, the SEM-EDS-EBSD apparatus was used, and the method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows. (3) For the region that was specified as the Si phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Si phase. Herein, an average value obtained by Area average (area-weighted average) was used for average calculation. In calculating the average diameter of the Si phase in the L cross-section, only Si phases having a diameter (equivalent circle diameter) equal to or larger than 0.5 μm were considered as targets.

The average diameter of the Si phase was calculated as an average value (arithmetic mean) of respective values obtained for measurement regions at three parts through the procedures from (1) to (3) described above.

(Method for measuring shape of Si phase)

In measuring the shape ratio (e/f) of the Si phase in the L cross-section of the Al bonding wire or the Al bonding ribbon, similarly to measurement of the orientation ratio of the crystal orientation of the Al phase, the SEM-EDS-EBSD apparatus was used, and a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.
(3) For the region that was specified as the Si phase, the crystal orientation was analyzed, and if the orientation difference between measurement points was equal to or larger than 15°, it was determined to be the crystal grain boundary, and the shape ratio (e/f) of each crystal grain was obtained. An average of the shape ratios (e/f) of the respective crystal grains was calculated to obtain the average value of the shape ratio (e/f) of the Si phase. Herein, as the average value of the shape ratio (e/f) of the Si phase, a numerical value of Grain Shape Aspect Ratio ("grain shape aspect ratio") of the analysis software was used. Regarding the method for calculating the grain shape aspect ratio, the ratio (e/f) between the short side length (e) (Grain Shape Minor Axis) and the long side length (f) (Grain Shape Major Axis) of one crystal grain is automatically calculated by software. Herein, an average value obtained by Area average (area-weighted average) was used for average calculation.
The shape ratio (e/f) of the Si phase was calculated as an average value (arithmetic mean) of respective values obtained for measurement regions at three parts through the procedures from (1) to (3) described above.

(Method for evaluating Al bonding wire or Al bonding ribbon)

The following describes a method for evaluating the Al bonding wire. The wire diameter of the Al bonding wire used for evaluation was Φ300 μm. The semiconductor chip made of Si was used, and as the electrode on the semiconductor chip, used was an alloy having a composition of Al-0.5%Cu deposited to have a thickness of 4 μm. As a substrate, 5 μm of Ni was deposited on an Al alloy. For bonding of the Al bonding wire, a commercially available wire bonder (manufactured by ULTRASONIC ENGINEERING CO., LTD.) was used, and wedge bonding was used for both of the 1st bonding (bonding with the electrode described above on the semiconductor chip) and the 2nd bonding (bonding with the substrate described above). For bonding of the Al bonding ribbon, a fully automatic bonder "BJ955" that is manufactured by Hesse GmbH and equipped with a ribbon bond head was used.

(Method for evaluating rapid temperature cycle reliability)

For the rapid temperature cycle test (rapid TCT), a commercially available rapid-rate thermal shock test apparatus was used. In the rapid TCT, hot air is blown to a sample to perform rapid heating. A sample to be subjected to the rapid TCT had a structure in which a semiconductor chip was mounted on a substrate, and an electrode on the semiconductor chip was connected with an electrode on the substrate via the Al bonding wire or the Al bonding ribbon. Heating and cooling were performed as one cycle to repeatedly apply a thermal load to the sample placed in a sample chamber of the rapid-rate thermal shock test apparatus. A minimum temperature at the time of cooling was -50°C, and a maximum temperature at the time of heating was 175°C. A heating time including a temperature rising time was 20 seconds, and a cooling time including a temperature falling time was 40 seconds. After the test was started, the sample was taken out after 20,000 cycles, and a shear force test was performed on the 1st bonding part. As a value of shear force of the 1st bonding part used for evaluating the rapid temperature cycle reliability, an average value of shear force of 1st bonding parts at ten points, which were randomly extracted, was used. A force retention rate was defined to be a ratio (percentage) of average shear force after performing the rapid TCT to average shear force before the test. As the force retention rate is higher, reliability of the bonding part is more excellent. If the force retention rate was equal to or larger than 85%, it was determined to be excellent and described as "3". If the force retention rate was equal to or larger than 75% and smaller than 85%, it was determined to be excellent and described as "2". If the force retention rate was equal to or larger than 70% and smaller than 75%, it was determined that improvement was required and described as "1". If the force retention rate was smaller than 70%, it was determined that a problem was caused in a practical use and described as "0". It was determined that "3" and "2" were acceptable, and "1" and "0" were unacceptable. Evaluation results are described in a column of "Rapid temperature cycle reliability" in tables. A requirement for the rapid temperature cycle reliability of a next-generation SiC semiconductor corresponds to 20,000 cycles.

(Method for evaluating variation in bonding strength in rapid temperature cycle test)

In the rapid TCT described above, shear force was measured for 1st bonding parts at twenty parts after 20,000 cycles of the test. In evaluating variation in bonding strength in the rapid TCT, an unbiased standard deviation (σ) of shear force was calculated. Since an unbiased standard deviation of shear force of the 1st bonding part is less likely to be

influenced by conditions of the 1st bonding, it is useful as an index for appropriately evaluating characteristics of the Al bonding wire or the Al bonding ribbon. If $\sigma$ was smaller than 30 gf, it was determined that variation in bonding strength was particularly small and stability was excellent, and evaluated as "3". If $\sigma$ was equal to or larger than 30 gf and smaller than 50 gf, it was determined that variation in bonding strength was small and stability was excellent, and evaluated as "2". If $\sigma$ was equal to or larger than 50 gf and smaller than 70 gf, it was determined that variation in bonding strength fell within a permissible range and stability was favorable, and evaluated as "1". If $\sigma$ was equal to or larger than 70 gf, it was determined that variation in bonding strength was large and there was a problem in a practical use, and described as "0". Evaluation results are described in a column of "Variation in bonding strength in rapid TCT" in the tables.

(Method for evaluating 1st bonding strength)

The following describes a method for evaluating the 1st bonding strength. The 1st bonding strength was evaluated by a shear force test. The 1st bonding was performed at ten parts under a bonding condition suitable for a reliability test, and the shear force of the 1st bonding part was measured. In this bonding condition, an ultrasonic output was set to be slightly high to secure a bonding area. For measurement of the shear force, a commercially available micro shear force tester (4000-PLUS manufactured by Nordson Corporation) was used. A shear rate was set to be 200 μm/sec, and a height of a shearing tool was set to be 10 μm from an electrode surface. The shear force was measured by fixing, with a jig, a substrate to which the Al bonding wire or the Al bonding ribbon was bonded. If the average value of the shear force of the 1st bonding part at the ten parts was equal to or larger than 1500 gf, it was determined to be excellent and evaluated as "3". If the average value of the shear force was equal to or larger than 1300 gf and smaller than 1500 gf, it was determined that there was no problem in a practical use and evaluated as "2". If the average value of the shear force was equal to or larger than 1000 gf and smaller than 1300 gf, it was determined that improvement was required and evaluated as "1". If the average value of the shear force was smaller than 1000 gf, it was determined that there was a problem in a practical use and evaluated as "0". Evaluation results are described in a column of "1st bonding strength" in the tables.

(Method for evaluating wire breakage during processing)

The following describes a method for evaluating wire breakage during processing. Wire-drawing processing was performed from a wire diameter of 6 mmφ to a wire diameter of 0.3 mmφ, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al bonding wire fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

(Method for evaluating scratch and scrape on surface)

A surface property of the Al bonding wire or the Al bonding ribbon was evaluated focusing on scratches and scrapes. The wire diameter of the Al bonding wire was Φ300 μm. A thickness of the Al bonding ribbon was 100 μm, and a width thereof was 600 μm. Measurement regions at three parts were randomly selected at intervals of 1 m or more with respect to the center axis direction of the Al bonding wire or the Al bonding ribbon, and three samples each having a length of about 2 cm were taken at each of the three parts to observe nine samples in total. Specifically, the surface was observed with magnification in a range from 50-fold to 500-fold using the SEM. A scratch having a length equal to or larger than 50 μm or a scrape having a length equal to or larger than 30 μm were determined to be defects. Parts of scratches or scrapes were counted. If the number thereof was 0, it was determined to be favorable and acceptable, and evaluated as "3". If the number thereof was equal to or larger than 1 and equal to or smaller than 2, it was determined that there was no problem in a practical use and evaluated as "2". If the number thereof was 3 to 7, it was determined that the surface property was not good, and evaluated as "1". If the number thereof was equal to or larger than 8, it was determined that a practical use was difficult to be achieved and evaluated as "0". Evaluation results are described in a column of "Surface property" in the tables.

The evaluation results of Examples and Comparative Examples are indicated in Table 1 to Table 4. Examples 1 to 44 and Comparative Examples 1 to 10 in Table 1 to Table 3 are results related to the Al bonding wire, and Examples B1 to B3 and Comparative Example B1 in Table 4 are results related to the Al bonding ribbon.

[Table 1]

(Table 1)

| | No. | Contained elements and concentration | | | | | | | | | | | | Ratio of <100> of Al phase in RD direction (%) | Small-diameter ratio of Si phase (Ns/Nc × 100) (%) | <110>+<111> total ratio of Si phase in ND direction(%) | Shape of Si phase (e/f) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Fe (mass ppm) | P (mass ppm) | Ti (mass ppm) | Mg (mass ppm) | Ni (mass ppm) | Cu (mass ppm) | Other elements (mass ppm) | Total of first element group (mass ppm) | Total of second element group (mass ppm) | | | | | | Rapid temperature cycle reliability | Variation in bonding strength in rapid TCT | 1st bonding strength | Wire breakage during processing | Surface property |
| Example | 1 | 3.0 | | | | | | | | | | 0 | 0 | 25 | 95 | 32 | 0.62 | 0.7 | 3 | 3 | 3 | 2 | 2 |
| | 2 | 4.0 | | | | | | | | | | 0 | 0 | 50 | 73 | 34 | 0.58 | 2.1 | 3 | 3 | 3 | 2 | 2 |
| | 3 | 4.7 | | | | | | | | | | 0 | 0 | 33 | 60 | 55 | 0.73 | 2.4 | 3 | 3 | 1 | 2 | 2 |
| | 4 | 5.1 | | | | | | | | | | 0 | 0 | 41 | 40 | 37 | 0.54 | 3.8 | 2 | 3 | 3 | 2 | 2 |
| | 5 | 5.6 | | | | | | | | | | 0 | 0 | 25 | 60 | 28 | 0.35 | 2.9 | 3 | 3 | 3 | 2 | 2 |
| | 6 | 6.0 | | | | | | | | | | 0 | 0 | 18 | 79 | 33 | 0.45 | 1.8 | 2 | 3 | 3 | 2 | 2 |
| | 7 | 6.3 | | | | | | | | | | 0 | 0 | 40 | 44 | 22 | 0.25 | 3.8 | 2 | 2 | 3 | 2 | 2 |
| | 8 | 7.0 | | | | | | | | | | 0 | 0 | 30 | 92 | 43 | 0.38 | 1.3 | 3 | 3 | 3 | 2 | 2 |
| | 9 | 7.1 | | | | | | | | | | 0 | 0 | 47 | 54 | 51 | 0.40 | 2.8 | 3 | 3 | 3 | 2 | 2 |
| | 10 | 7.5 | | | | | | | | | | 0 | 0 | 15 | 68 | 36 | 0.55 | 2.2 | 2 | 3 | 3 | 2 | 2 |
| | 11 | 7.8 | | | | | | | | | | 0 | 0 | 38 | 60 | 45 | 0.61 | 2.5 | 3 | 3 | 3 | 2 | 2 |
| | 12 | 8.0 | | | | | | | | | | 0 | 0 | 47 | 95 | 37 | 0.43 | 0.8 | 3 | 3 | 3 | 2 | 2 |
| | 13 | 8.5 | | | | | | | | | | 0 | 0 | 48 | 58 | 23 | 0.44 | 2.4 | 3 | 2 | 3 | 2 | 2 |
| | 14 | 9.0 | | | | | | | | | | 0 | 0 | 22 | 50 | 25 | 0.24 | 2.6 | 3 | 3 | 2 | 2 | 2 |
| | 15 | 10.8 | | | | | | | | | | 0 | 0 | 41 | 81 | 32 | 0.35 | 1.7 | 3 | 3 | 2 | 2 | 2 |
| | 16 | 12.7 | | | | | | | | | | 0 | 0 | 20 | 56 | 56 | 0.42 | 2.5 | 2 | 3 | 3 | 2 | 2 |
| | 17 | 14.8 | | | | | | | | | | 0 | 0 | 32 | 37 | 42 | 0.17 | 4.0 | 2 | 3 | 1 | 2 | 2 |
| | 18 | 16.6 | | | | | | | | | | 0 | 0 | 38 | 47 | 35 | 0.35 | 3.0 | 3 | 3 | 3 | 2 | 2 |

[Table 2]

(Table 2)

| | No. | Contained elements and concentration | | | | | | | | | | | | Ratio of <100> of Al phase in RD direction (%) | Small-diameter ratio of Si phase (Ns/Nc×100) (%) | <110>+<111> total ratio of Si phase in ND direction(%) | Shape of Si phase (e/f) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Fe (mass ppm) | P (mass ppm) | Ti (mass ppm) | Mg (mass ppm) | Ni (mass ppm) | Cu (mass ppm) | Other elements (mass ppm) | Total of first element group (mass ppm) | Total of second element group (mass ppm) | | | | | | Rapid temperature cycle reliability | Variation in bonding strength in rapid TCT | 1st bonding strength | Wire breakage during processing | Surface property |
| Example | 19 | 5.6 | 8 | | | | | | | | | 8 | 0 | 18 | 68 | 37 | 0.65 | 1.4 | 2 | 3 | 3 | 2 | 2 |
| | 20 | 7.1 | 90 | | | | | | | | | 90 | 0 | 26 | 55 | 40 | 0.53 | 2.1 | 3 | 3 | 3 | 3 | 2 |
| | 21 | 8.2 | 450 | | | | | | | | | 450 | 0 | 34 | 79 | 44 | 0.42 | 1.2 | 3 | 3 | 3 | 3 | 2 |
| | 22 | 3.4 | | 65 | | | | | | | | 65 | 0 | 36 | 54 | 32 | 0.32 | 2.4 | 3 | 3 | 3 | 3 | 2 |
| | 23 | 8.4 | | 370 | | | | | | | | 370 | 0 | 46 | 95 | 62 | 0.71 | 0.8 | 3 | 2 | 3 | 3 | 2 |
| | 24 | 5.2 | | | 10 | | | | | | | 10 | 0 | 24 | 81 | 35 | 0.23 | 1.8 | 3 | 3 | 2 | 3 | 2 |
| | 25 | 6.8 | | | 400 | | | | | | | 400 | 0 | 33 | 68 | 23 | 0.32 | 2.2 | 3 | 2 | 3 | 3 | 2 |
| | 26 | 4.7 | | | | 105 | | | | | | 105 | 0 | 36 | 55 | 46 | 0.55 | 3.2 | 3 | 3 | 3 | 3 | 2 |
| | 27 | 7.3 | 100 | | 40 | | | | | | | 140 | 0 | 44 | 66 | 37 | 0.58 | 2.6 | 3 | 3 | 3 | 3 | 2 |
| | 28 | 10.3 | 350 | 430 | | | | | | | | 780 | 0 | 25 | 49 | 35 | 0.64 | 2.2 | 3 | 3 | 3 | 3 | 2 |
| | 29 | 6.4 | 34 | | 250 | 30 | | | | | Mn: 1750 | 314 | 0 | 36 | 45 | 36 | 0.24 | 3.5 | 2 | 3 | 2 | 3 | 2 |
| | 30 | 5.5 | | 250 | 420 | 140 | | | | | | 810 | 0 | 18 | 58 | 44 | 0.53 | 2.7 | 2 | 3 | 3 | 2 | 2 |
| | 31 | 7.0 | | | | | 100 | | | | | 0 | 100 | 29 | 73 | 35 | 0.31 | 1.9 | 3 | 3 | 3 | 2 | 3 |
| | 32 | 5.5 | | | | | 1100 | | | | | 0 | 1100 | 38 | 40 | 51 | 0.44 | 3.8 | 2 | 3 | 3 | 2 | 3 |
| | 33 | 3.8 | | | | | | 92 | | | | 0 | 92 | 50 | 54 | 20 | 0.32 | 2.8 | 3 | 2 | 3 | 2 | 2 |
| | 34 | 6.6 | | | | | | | 55 | | | 0 | 55 | 32 | 68 | 29 | 0.49 | 2.3 | 3 | 3 | 3 | 2 | 2 |
| | 35 | 7.2 | | | | | | | 750 | | | 0 | 750 | 40 | 58 | 38 | 0.42 | 2.4 | 3 | 3 | 3 | 2 | 3 |
| | 36 | 5.7 | | | | | 750 | | | 750 | | 0 | 1500 | 30 | 51 | 32 | 0.56 | 3.1 | 3 | 3 | 3 | 2 | 3 |
| | 37 | 7.0 | | | | | | | 100 | 400 | | 0 | 500 | 36 | 58 | 45 | 0.64 | 2.6 | 3 | 3 | 3 | 2 | 3 |
| | 38 | 15.5 | | | | | 80 | 40 | 420 | | | 0 | 540 | 18 | 65 | 18 | 0.37 | 3.3 | 2 | 1 | 3 | 2 | 3 |
| | 39 | 7.2 | | | | | 600 | 200 | 750 | 520 | | 0 | 2070 | 30 | 51 | 35 | 0.22 | 2.9 | 3 | 3 | 2 | 2 | 2 |
| | 40 | 9.7 | 150 | | 125 | | 400 | | | 50 | | 275 | 450 | 42 | 72 | 41 | 0.65 | 1.8 | 3 | 3 | 3 | 3 | 3 |
| | 41 | 4.9 | | 180 | | 80 | 200 | | 120 | | | 260 | 320 | 25 | 54 | 60 | 0.50 | 2.7 | 3 | 3 | 3 | 3 | 3 |
| | 42 | 7.2 | 60 | | 200 | | | | 150 | | Zn: 2300 | 260 | 150 | 47 | 67 | 33 | 0.46 | 2.2 | 3 | 3 | 3 | 3 | 3 |
| | 43 | 8.6 | 200 | 210 | | | 820 | 100 | 450 | 300 | | 410 | 1670 | 33 | 91 | 51 | 0.52 | 1.8 | 3 | 3 | 3 | 3 | 3 |
| | 44 | 6.4 | | | 220 | 130 | 250 | 150 | | | | 350 | 400 | 36 | 56 | 43 | 0.32 | 2.8 | 3 | 3 | 3 | 3 | 3 |

[Table 3]

(Table 3)

| | No. | Contained elements and concentration | | | | | | | | | | Total of first element group (mass ppm) | Total of second element group (mass ppm) | Ratio of <100> of Al phase in RD direction (%) | Small-diameter ratio of Si phase (Ns/Nc × 100) (%) | <110>+<111> total ratio of Si phase in ND direction(%) | Shape of Si phase (e/f) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Fe (mass ppm) | P (mass ppm) | Ti (mass ppm) | Mg (mass ppm) | Ni (mass ppm) | Cu (mass ppm) | Other elements (mass ppm) | | | | | | | | Rapid temperature cycle reliability | Variation in bonding strength in rapid TCT | 1st bonding strength | Wire breakage during processing | Surface property |
| Comparative example | 1 | 0.0 | | | | | | | | | | 0 | 0 | 28 | — | — | — | — | 0 | 0 | 0 | 2 | 2 |
| | 2 | 2.5 | | | | | | | | | | 0 | 0 | 32 | 72 | 44 | 0.64 | 1.2 | 0 | 0 | 0 | 2 | 1 |
| | 3 | 25.4 | | | | | | | | | | 0 | 0 | 28 | 42 | 28 | 0.23 | 3.9 | 1 | 1 | 0 | 0 | 0 |
| | 4 | 6.2 | | | | | | | | | | 0 | 0 | 14 | 56 | 31 | 0.25 | 2.8 | 1 | 1 | 0 | 1 | 1 |
| | 5 | 4.4 | | | | | | | | | | 0 | 0 | 52 | 65 | 29 | 0.62 | 2.4 | 1 | 1 | 0 | 1 | 1 |
| | 6 | 7.5 | | | | | | | | | | 0 | 0 | 23 | 18 | 45 | 0.33 | 4.3 | 1 | 1 | 0 | 1 | 1 |
| | 7 | 8.7 | | 480 | | | | | | | | 480 | 0 | 25 | 97 | 36 | 0.71 | 1.1 | 1 | 1 | 0 | 2 | 1 |
| | 8 | 7.0 | | | | 50 | 200 | | | 500 | | 50 | 700 | 13 | 64 | 42 | 0.37 | 2.6 | 1 | 1 | 0 | 2 | 2 |
| | 9 | 5.8 | 260 | | | | | 200 | | | | 260 | 200 | 52 | 73 | 37 | 0.57 | 1.9 | 1 | 1 | 1 | 2 | 2 |
| | 10 | 9.5 | | | 120 | | | | 250 | | | 120 | 250 | 25 | 8 | 40 | 0.60 | 4.0 | 1 | 1 | 0 | 2 | 2 |

[Table 4]

(Table 4)

| | No. | Contained elements and concentration | | | | | | | | | | | | Ratio of <100> of Al phase in RD direction (%) | Small-diameter ratio of Si phase (Ns/Nc × 100) (%) | <110>+<111> total ratio of Si phase in ND direction(%) | Shape of Si phase (e/f) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Fe (mass ppm) | P (mass ppm) | Ti (mass ppm) | Mg (mass ppm) | Ni (mass ppm) | Cu (mass ppm) | Other elements (mass ppm) | Total of first element group (mass ppm) | Total of second element group (mass ppm) | | | | | | Rapid temperature cycle reliability | Variation in bonding strength in rapid TCT | 1st bonding strength | Wire breakage during processing | Surface property |
| Example | B1 | 4.6 | | | | | | | 61 | 105 | | 0 | 166 | 24 | 92 | 32 | 0.52 | 1.5 | 3 | 3 | 3 | 1 | 2 |
| | B2 | 8.1 | 87 | | | | | | | | | 87 | 0 | 44 | 69 | 47 | 0.36 | 2.8 | 3 | 3 | 3 | 2 | 1 |
| | B3 | 15.0 | 175 | | 25 | | 122 | | | 105 | | 200 | 227 | 32 | 48 | 36 | 0.30 | 1.4 | 3 | 3 | 3 | 2 | 2 |
| Comparative example | B1 | 9.5 | | | | 45 | | | | | | 45 | 0 | 13 | 28 | 28 | 0.18 | 3.1 | 1 | 1 | 1 | 1 | 1 |

[Description of reference signs]

1 Al bonding wire
10 center axis
11 L cross-section
2 Al bonding ribbon
20 center axis
21 L cross-section
3 Al bonding wire or Al bonding ribbon
31 Si phase
32 center axis direction of Al bonding wire or Al bonding ribbon

## Claims

**1.** An Al bonding wire or an Al bonding ribbon containing 3.0% by mass or more and 20.0% by mass or less of Si, wherein

when a crystal orientation of an Al phase in an L cross-section (cross section in a center axis direction including a center axis) of the Al bonding wire or the Al bonding ribbon is measured, an orientation ratio of a <100> crystal orientation angled at 15° or less to a direction parallel to the center axis (RD direction) is equal to or larger than 15% and equal to or smaller than 50%, and
when Ns denotes the number of Si phases having an equivalent circle diameter equal to or larger than 0.5 μm and equal to or smaller than 0.8 μm in the L cross-section and Nc denotes the number of Si phases having an equivalent circle diameter equal to or larger than 0.5 μm in the L cross-section, a ratio of Ns to Nc [Ns/Nc × 100 (%)] is equal to or larger than 30% and equal to or smaller than 95%.

**2.** The Al bonding wire or the Al bonding ribbon according to claim 1, wherein the ratio of Ns to Nc [Ns/Nc × 100 (%)] is equal to or larger than 40%.

**3.** The Al bonding wire or the Al bonding ribbon according to claim 1 or 2, wherein, when a crystal orientation of the Si phase in the L cross-section is measured, a total of orientation ratios of a <100> crystal orientation and a <111> crystal orientation angled at 15° or less to a direction perpendicular to the center axis (ND direction) is equal to or larger than 20% and equal to or smaller than 60%.

**4.** The Al bonding wire or the Al bonding ribbon according to any one of claims 1 to 3, wherein an average value of a ratio between a short side length e and a long side length f (e/f) of the Si phase in the L cross-section is equal to or larger than 0.20 and equal to or smaller than 0.70.

**5.** The Al bonding wire or the Al bonding ribbon according to any one of claims 1 to 4, further containing 10 mass ppm or more and 800 mass ppm or less of one or more of Sr, Na, Fe, and P in total.

**6.** The Al bonding wire or the Al bonding ribbon according to any one of claims 1 to 5, further containing 100 mass ppm or more and 2000 mass ppm or less of one or more of Ti, Ni, Mg, and Cu in total.

**7.** The Al bonding wire or the Al bonding ribbon according to any one of claims 1 to 6, wherein a total concentration of elements other than Al, Si, Sr, Na, Fe, P, Ti, Ni, Mg, and Cu in the Al bonding wire or the Al bonding ribbon is equal to or smaller than 0.5% by mass.

**8.** The Al bonding wire or the Al bonding ribbon according to any one of claims 1 to 7, wherein the orientation ratio of the crystal orientation, the equivalent circle diameter of the Si phase, and the number of Si phases are values measured by using a SEM-EDS-EBSD apparatus.

**9.** The Al bonding wire or the Al bonding ribbon according to any one of claims 4 to 8, wherein the average value of the ratio between the short side length e and the long side length f (e/f) of the Si phase is a value measured by using a SEM-EDS-EBSD apparatus.

10. The Al bonding wire or the Al bonding ribbon according to any one of claims 1 to 9, used for a semiconductor device.

11. A semiconductor device comprising the Al bonding wire or the Al bonding ribbon according to any one of claims 1 to 10.

FIG.1

ND
1
11
RD
10

FIG.2

2
21
ND
W
20
RD
T

FIG.3

3
f
31
e
32

FIG.4

900
800
700
600
500
400
300
200
100
0
NUMBER OF Si PHASES
0.5
1
1.5
2
2.5
3
3.5
4
0.5-0.8 μm
EQUIVALENT CIRCLE DIAMETER OF Si PHASE /μm

# INTERNATIONAL SEARCH REPORT

International application No.
**PCT/JP2024/042019**

**A. CLASSIFICATION OF SUBJECT MATTER**

***H01L 21/60***(2006.01)i; ***C22C 21/02***(2006.01)i; ***C22F 1/00***(2006.01)i; ***C22F 1/043***(2006.01)i
FI: H01L21/60 301F; C22C21/02; C22F1/00 605; C22F1/00 614; C22F1/00 625; C22F1/00 630G; C22F1/00 650A; C22F1/00 661Z; C22F1/00 681; C22F1/00 682; C22F1/00 685Z; C22F1/00 686A; C22F1/00 691B; C22F1/00 691C; C22F1/00 691Z; C22F1/00 694A; C22F1/00 694Z; C22F1/043

According to International Patent Classification (IPC) or to both national classification and IPC

**B. FIELDS SEARCHED**

Minimum documentation searched (classification system followed by classification symbols)

H01L21/60; C22C21/02-21/04; C22F1/00; C22F1/043

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2010-140993 A (FUJI ELECTRIC SYSTEMS CO., LTD.) 24 June 2010 (2010-06-24) | 1-11 |
| A | WO 2022/168787 A1 (NIPPON MICROMETAL CORPORATION) 11 August 2022 (2022-08-11) | 1-11 |
| A | WO 2022/168794 A1 (NIPPON MICROMETAL CORPORATION) 11 August 2022 (2022-08-11) | 1-11 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 January 2025** | **28 January 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/042019**

| Patent document cited in search report | Publication date (day/month/year) | Patent family member(s) | Publication date (day/month/year) |
|---|---|---|---|
| JP 2010-140993 A | 24 June 2010 | (Family: none) | |
| WO 2022/168787 A1 | 11 August 2022 | US 2024/0071978 A1 | |
| | | EP 4289983 A1 | |
| | | CN 116918049 A | |
| | | TW 202235634 A | |
| WO 2022/168794 A1 | 11 August 2022 | US 2024/0312946 A1 | |
| | | EP 4289986 A1 | |
| | | CN 116848624 A | |
| | | TW 202239982 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014131010 A
- JP 2014129578 A
- JP 59057440 A
- JP 2020150116 A